# EUROPEAN PATENT SPECIFICATION

(11) **EP 3 985 691 B1**
(45) Date of publication and mention of the grant of the patent: **22.01.2025**
(21) Application number: 21201949.1
(22) Date of filing: 11.10.2021
(51) Int. Cl.: H01F 1/26, H01F 1/34, H01F 1/37, H01F 1/00, H01F 27/29, H01F 17/00, H05K 1/16, H01F 41/16, H01F 41/04

(54) **USE OF MAGNETIC PASTE, CIRCUIT BOARD, AND METHOD OF ITS PRODUCTION**
VERWENDUNG EINER MAGNETISCHEN PASTE; LEITERPLATTE UND DEREN PRODUKTION
UTILISATION D'UNE PÂTE MAGNÉTIQUE, PLAQUE CONDUCTEUR, ET PROCÉDÉ DE LA PRODUCTION DU PLAQUE CONDUCTEUR

(30) Priority: 14.10.2020 JP 2020173238
(43) Date of publication of application: 20.04.2022
(73) Proprietor: AJINOMOTO CO., INC., Chuo-ku Tokyo 104-8315 (JP)
(72) Inventor: TANAKA, Takayuki, Kanagawa 210-0801 (JP); SATO, Naoya, Kanagawa 210-0801 (JP); YAMABE, Osamu, Kanagawa 210-0801 (JP)
(74) Representative: Mewburn Ellis LLP

(56) References cited:
- EP-A1- 3 828 901
- EP-B1- 0 158 406
- WO-A1-2020/022393
- WO-A1-2020/203277
- WO-A1-94/21368
- JP-A- 2013 127 613
- JP-A- 2020 013 943
- US-A1- 2013 034 812
- US-A1- 2016 276 076
- US-B2- 8 852 840

## Description

### BACKGROUND OF THE INVENTION

### 1. Field of the Invention

The present invention relates to a use of a magnetic paste for through-hole filling, a circuit board with the cured resin composition, and a method for producing the circuit board.

### 2. Description of the Related Art

In recent years, with demands for downsizing and slimming down of electronic devices, downsizing of a circuit board to be used for electronic devices and high densification of wirings in the circuit board have been required. As such circuit board, there is known a circuit board formed by filling a through hole with a paste material.

For example, Japanese Patent Application Laid-open No. 2016-197624 describes a filling resin containing magnetic substance particles, such as ferric oxide (III) or cobalt ferrite, as a resin with which a through hole in a circuit board for inductor components is filled. WO 2020/022393 A1 discloses a resin composition for through-hole filling with an acidic dispersant.

### SUMMARY OF THE INVENTION

In order to enhance the relative magnetic permeability of a cured product of a magnetic paste, which will also be addressed as a resin composition, like a filling resin described in Japanese Patent Application Laid-open No. 2016-197624, a method by which a filling resin contains magnetic powder can be employed. However, when a magnetic paste contains magnetic powder, the magnetic paste has a higher viscosity, so that the magnetic paste sometimes has poor printability. In particular, when a paste containing magnetic powder in large amounts, such as the filling resin described in Japanese Patent Application Laid-open No. 2016-197624, is used, the viscosity of the paste is greatly increased, so that the paste has poorer printability.

The present invention has been made in view of the circumstances described above, and an object of the present invention is to provide a magnetic paste and a resin composition that are capable of achieving a cured product having higher relative magnetic permeability and are excellent in printability, and a cured product, a circuit board, and an inductor component in each of which the magnetic paste or the resin composition is used.

To achieve the above-described object, the inventors carried out intensive studies, and found that, when a magnetic paste containing a dispersant having a polyester skeleton was used, the viscosity of the paste was lowered to enhance printability while the relative magnetic permeability of the cured product was enhanced, and thus the present invention was completed.

The present invention specifies the use of the magnetic paste for through-hole filling in claim 1, the circuit board with the cured magnetic paste in its through-hole in claim 8, and the respective method in claim 12.

### EFFECT OF THE INVENTION

According to the present invention, there can be provided a magnetic paste for through-hole filling which is capable of achieving a cured product having higher relative magnetic permeability and are excellent in printability, and a cured product, a circuit board, and an inductor component in each of which the magnetic paste is used.

### BRIEF DESCRIPTION OF THE DRAWINGS

FIG. 1 is a schematic cross-sectional view of a core substrate as an example of a method of manufacturing a circuit board of a first embodiment;
FIG. 2 is a schematic cross-sectional view of the core substrate having a through hole formed therein, as an example of the method of manufacturing the circuit board of the first embodiment;
FIG. 3 is a schematic cross-sectional view illustrating a state of the core substrate in which a plating layer is formed in the through hole, as an example of the method of manufacturing the circuit board of the first embodiment;
FIG. 4 is a schematic cross-sectional view illustrating a state of the core substrate in which the through hole is filled with a magnetic paste, as an example of the method of manufacturing the circuit board of the first embodiment;
FIG. 5 is a schematic cross-sectional view illustrating a state of the core substrate in which the filling magnetic paste is heat-cured, as an example of the method of manufacturing the circuit board of the first embodiment;
FIG. 6 is a schematic cross-sectional view illustrating a state of the core substrate observed after the polishing of a cured product, as an example of the method of manufacturing the circuit board of the first embodiment;
FIG. 7 is a schematic cross-sectional view illustrating a state of the core substrate in which a conductive layer is formed on a polished surface, as an example of the method of manufacturing the circuit board of the first embodiment;
FIG. 8 is a schematic cross-sectional view illustrating a state of the core substrate in which a pattern conductive layer is formed, as an example of the method of manufacturing the circuit board of the first embodiment;
FIG. 9 is a schematic cross-sectional view to describe a process (A) included in an example of a method of manufacturing a circuit board of a second embodiment;
FIG. 10 is a schematic cross-sectional view to describe the process (A) included in an example of the method of manufacturing the circuit board of the second embodiment;
FIG. 11 is a schematic cross-sectional view to describe a process (B) included in an example of the method of manufacturing the circuit board of the second embodiment;
FIG. 12 is a schematic cross-sectional view to describe a process (D) included in an example of the method of manufacturing the circuit board of the second embodiment;
FIG. 13 is a schematic plan view of an inductor component including the circuit board obtained by the method of manufacturing the circuit board of the second embodiment as an example, when seen from one side in the thickness direction of the inductor component;
FIG. 14 is a schematic diagram of an end cross-section of the inductor component including the circuit board obtained by the method of manufacturing the circuit board of the second embodiment as an example, when taken along a dot-and-dash line II-II; and
FIG. 15 is a schematic plan view to describe a configuration of a first conductive layer of the inductor component including the circuit board obtained by the method of manufacturing the circuit board of the second embodiment as an example.

### DETAILED DESCRIPTION OF THE PREFERRED EMBODIMENTS

Hereinafter, embodiments of the present invention will be described with reference to the drawings. Note that the drawings just schematically illustrate the shape, size, and arrangement of constituents to the extent of aiding the understanding of the invention. The present invention is not limited by the following descriptions, and constituents may be suitably changed. In the drawings used for the following descriptions, similar constituents are assigned with the same reference sign, and any redundant description may be omitted. Configurations according to the embodiments of the present invention are not necessarily produced or used in accordance with the illustrated arrangement examples.

### Magnetic paste

A magnetic paste of the present invention contains magnetic powder (A), an epoxy resin (B), a dispersant (C), and a curing agent (D), in which the component (C) has a polyester skeleton represented by the following formula (1) . 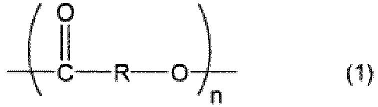 (In the formula (1), R is independently a divalent hydrocarbon group having 2 to 10 carbon atoms, and n is an integer of 2 to 1,000.)

In the present invention, the magnetic paste contains the dispersant (C), so that the magnetic paste has a lower viscosity and is more excellent in printability. Furthermore, a cured product of the magnetic paste can usually have higher mechanical strength. Furthermore, the cured product of the magnetic paste usually can have higher relative magnetic permeability in a frequency range of 10 MHz to 200 MHz and achieve a reduction in magnetic loss in the frequency range.

The magnetic paste may further contain other additives (E), if needed. Hereinafter, components contained in the magnetic paste of the present invention will be described in detail.

### (A) Magnetic powder

The magnetic paste contains the magnetic powder (A) as a component (A). The magnetic powder (A) may be used alone, or two or more kinds thereof may be used in combination. Examples of the magnetic powder (A) include pure iron powder; iron oxide powder, such as Mg-Zn-based ferrite, Fe-Mn-based ferrite, Mn-Zn-based ferrite, Mn-Mg-based ferrite, Cu-Zn-based ferrite, Mg-Mn-Sr-based ferrite, Ni-Zn-based ferrite, Ba-Zn-based ferrite, Ba-Mg-based ferrite, Ba-Ni-based ferrite, Ba-Co-based ferrite, Ba-Ni-Co-based ferrite, Y-based ferrite, ferric oxide powder (III), and triiron tetraoxide; iron alloy-based metal powder, such as Fe-Si-based alloy powder, Fe-Si-Al-based alloy powder, Fe-Cr-based alloy powder, Fe-Cr-Si-based alloy powder, Fe-Ni-Cr-based alloy powder, Fe-Cr-Al-based alloy powder, Fe-Ni-based alloy powder, Fe-Ni-Mo-based alloy powder, Fe-Ni-Mo-Cu-based alloy powder, Fe-Co-based alloy powder, and Fe-Ni-Co-based alloy powder; and amorphous alloys, such as a Co-group amorphous alloy.

In particular, the magnetic powder (A) is preferably at least one selected from iron oxide powder and iron alloy-based metal powder. As the iron oxide powder, ferrite containing at least one selected from Ni, Cu, Mn, and Zn is preferably contained, and ferrite containing Mn is more preferably contained. As the iron alloy-based metal powder, iron alloy-based metal powder containing at least one selected from Si, Cr, Al, Ni, and Co is preferably contained.

As the magnetic powder (A), commercially available magnetic powder can be used. Specific examples of the commercially available magnetic powder to be used include M05S and M001, manufactured by Powdertech Co., Ltd.; PST-S, manufactured by Sanyo Special Steel Co., Ltd; AW2-08, AW2-08PF20F, AW2-08PF10F, AW2-08PF3F, Fe-3.5Si-4.5CrPF20F, Fe-50NiPF20F, and Fe-80Ni-4MoPF20F, manufactured by EPSON ATMIX Corporation; LD-M, LD-MH, KNI-106, KNI-106GSM, KNI-106GS, KNI-109, KNI-109GSM, and KNI-109GS, manufactured by JFE Chemical Corporation; KNS-415, BSF-547, BSF-029, BSN-125, BSN-125, BSN-714, BSN-828, S-1281, S-1641, S-1651, S-1470, S-1511, and S-2430, manufactured by TODA KOGYO CORP.; JR09P2, manufactured by Japan Metals & Chemicals Co., Ltd; NanoTek, manufactured by CIK NanoTek Corporation; JEMK-S and JEMK-H, manufactured by KINSEI MATEC CO., LTD; and Yttrium iron oxide, manufactured by ALDRICH.

The magnetic powder (A) may be used alone, but, two or more kinds thereof are preferably used in combination from the viewpoint of remarkably achieving the effect of the present invention.

The magnetic powder (A) preferably has a spherical shape. A value (an aspect ratio) obtained by dividing the length of the major axis of the magnetic powder by the length of the minor axis of the magnetic powder is preferably 2 or less, more preferably 1.5 or less, and still more preferably 1.2 or less. Generally, when the magnetic powder has not a spherical shape but a flat shape, relative magnetic permeability can be more easily enhanced. However, the magnetic powder having a spherical shape is particularly preferably used because, usually, magnetic loss can be reduced and a paste having a desirable viscosity can be achieved.

From the viewpoint of enhancing the relative magnetic permeability, the average particle diameter of the magnetic powder (A) is preferably 0.01 µm or larger, more preferably 0.5 um or larger, and still more preferably 1 um or larger. In addition, the average particle diameter of the magnetic powder (A) is preferably 10 um or smaller, more preferably 9 um or smaller, and still more preferably 8 um or smaller. Note that, in the case where two or more kinds of the magnetic powder (A) are used in combination, the average particle diameter of the entirety of the component (A) is beneficially within the above-mentioned range.

The average particle diameter of the magnetic powder (A) can be measured by laser diffraction scattering based on the Mie scattering theory. Specifically, the average particle diameter can be measured in such a manner that the particle size distribution of the magnetic powder is created on the basis of volume by using a laser diffraction scattering type particle size distribution measurement device, and a median diameter in the particle size distribution is taken as the average particle diameter. As a measurement sample, what is obtained by dispersing the magnetic powder in water by supersonic waves can be preferably used. As the laser diffraction scattering type particle size distribution measurement device, for example, LA-500, manufactured by HORIBA, Ltd. or SALD-2200, manufactured by SHIMADZU CORPORATION can be used.

From the viewpoint of enhancing relative magnetic permeability, the specific surface area of the magnetic powder (A) is preferably 0.05 m²/g or larger, more preferably 0.1 m²/g or larger, and still more preferably 0.3 m²/g or larger. In addition, the specific surface area of the magnetic powder (A) is preferably 10 m²/g or smaller, more preferably 8 m²/g or smaller, and still more preferably 5 m²/g or smaller. The specific surface area of the magnetic powder (A) can be measured by the Brunauer Emmett Teller (BET) method. Note that, in the case where two or more kinds of the magnetic powder (A) are used in combination, the specific surface area of the entirety of the component (A) is beneficially within the above-mentioned range.

From the viewpoint of enhancing the relative magnetic permeability, the magnetic powder (A) preferably contains magnetic powder (A-1) having an average particle diameter of 1 um or larger, and magnetic powder (A-2) having an average particle diameter of smaller than 1 µm.

The average particle diameter of the magnetic powder (A-1) having an average particle diameter of 1 um or larger is 1 um or larger, preferably 1.2 um or larger, and more preferably 1.5 um or larger. The upper limit of the average particle diameter of the component (A-1) is preferably 10 um or smaller, more preferably 9 um or smaller, and still more preferably 8 um or smaller. The average particle diameter of the component (A-1) can be measured by the above-described method.

The specific surface area of the component (A-1) is preferably 0.01 m²/g or larger, more preferably 0.05 m²/g or larger, and still more preferably 0.1 m²/g or larger. In addition, the specific surface area of the component (A-1) is preferably 2 m²/g or smaller, more preferably 1.5 m²/g or smaller, and still more preferably 1 m²/g or smaller. The specific surface area of the component (A-1) can be measured by the above-described method.

The average particle diameter of the magnetic powder (A-2) having an average particle diameter of smaller than 1 um is smaller than 1 um, preferably 0.8 um or smaller, and more preferably 0.5 um or smaller. The lower limit of the average particle diameter of the component (A-2) is preferably 0.005 um or larger, more preferably 0.01 um or larger, and still more preferably 0.02 um or larger. The average particle diameter of the component (A-2) can be measured by the above-described method.

The specific surface area of the component (A-2) is preferably 1 m²/g or larger, more preferably 2 m²/g or larger, and still more preferably 3 m²/g or larger. Furthermore, the specific surface area of the component (A-2) is preferably 500 m²/g or smaller, more preferably 400 m²/g or smaller, and still more preferably 300 m²/g or smaller. The specific surface area of the component (A-2) can be measured by the above-described method.

In a preferred embodiment, the component (A) preferably contains the magnetic powder (A-1) having an average particle diameter of 1 um or larger and 10 um or smaller, and the magnetic powder (A-2) having an average particle diameter of 0.005 um or larger and smaller than 1 µm, more preferably contains the magnetic powder (A-1) having an average particle diameter of 1.2 um or larger and 9 um or smaller, and the magnetic powder (A-2) having an average particle diameter of 0.01 um or larger and smaller than 0.8 um, and still more preferably contains the magnetic powder (A-1) having an average particle diameter of 1.5 um or larger and 8 um or smaller, and the magnetic powder (A-2) having an average particle diameter of 0.02 um or larger and smaller than 0.5 µm.

From the viewpoints of enhancing relative magnetic permeability and reducing loss, the content (% by volume) of the magnetic powder (A) is preferably 40% by volume or higher, more preferably 50% by volume or higher, and still more preferably 60% by volume or higher, with respect to 100% by volume of non-volatile components in the magnetic paste. In addition, the content of the magnetic powder (A) is preferably 85% by volume or lower, more preferably 80% by volume or lower, and still more preferably 70% by volume or lower.

From the viewpoints of enhancing relative magnetic permeability and reducing a loss factor, the content (% by mass) of the magnetic powder (A) is preferably 70% by mass or higher, more preferably 75% by mass or higher, and still more preferably 80% by mass or higher, with respect to 100% by mass of non-volatile components in the magnetic paste. In addition, the content of the magnetic powder (A) is preferably 98% by mass or lower, more preferably 95% by mass or lower, and still more preferably 90% by mass or lower.

Note that, in the present invention, the content of each of the components in the magnetic paste represents the amount of the component when the amount of non-volatile components in the magnetic paste is taken as 100% by mass, unless otherwise specified.

In the case where the component (A) contains the component (A-1) and the component (A-2), the content (% by mass) of the component (A-1) is preferably 70% by mass or higher, and still more preferably 65% by mass or higher with respect to 100% by mass of the non-volatile components in the magnetic paste, from the viewpoints of enhancing the relative magnetic permeability and reducing the loss factor. Furthermore, the content of the component (A-1) is preferably 98% by mass or lower, more preferably 95% by mass or lower, and still more preferably 90% by mass or lower.

In the case where the component (A) contains the component (A-1) and the component (A-2), the content (% by mass) of the component (A-2) is preferably 5% by mass or higher, more preferably 10% by mass or higher, and still more preferably 15% by mass or higher with respect to 100% by mass of the non-volatile components in the magnetic paste, from the viewpoints of enhancing the relative magnetic permeability and reducing the loss factor. Furthermore, the content of the component (A-2) is preferably 98% by mass or lower, more preferably 95% by mass or lower, and still more preferably 90% by mass or lower.

When the content of the component (A-1) is taken as a1 with respect to 100% by mass of non-volatile components in the magnetic paste and the content of the component (A-2) is taken as a2 with respect to 100% by mass of the non-volatile components in the magnetic paste, a(1)/a(2) is preferably 10 or less, more preferably 8 or less, and still more preferably 5 or less, and preferably 1 or more, more preferably 2 or more, and still more preferably 3 or more. The content of the component (A) is adjusted so as to achieve a(1)/a(2) within the above-mentioned range, so that the desired effects of the present invention can be more remarkably achieved.

### (B) Epoxy resin

The magnetic paste contains the epoxy resin (B) as a component (B). Examples of the epoxy resin (B) include a bisphenol A epoxy resin; a bisphenol F epoxy resin; a bisphenol S epoxy resin; a bisphenol AF epoxy resin; a dicyclopentadiene epoxy resin; a trisphenol epoxy resin; a phenol novolac epoxy resin; a tert-butyl-catechol epoxy resin; epoxy resins having a condensed ring structure, such as a naphthol novolac epoxy resin, a naphthalene epoxy resin, a naphthol epoxy resin, and an anthracene epoxy resin; a glycidyl amine epoxy resin; a glycidyl ester epoxy resin; a cresol novolac epoxy resin; a biphenyl epoxy resin; a linear aliphatic epoxy resin; an epoxy resin having a butadiene structure; a cycloaliphatic epoxy resin; a heterocyclic epoxy resin; a spiro ring-containing epoxy resin; a cyclohexane dimethanol epoxy resin; a trimethylol epoxy resin; a tetraphenyl ethane epoxy resin; and a cyclic aliphatic diglycidyl ether epoxy resin. The epoxy resins may be used alone or two or more kinds thereof may be used in combination. The epoxy resin (B) is preferably at least one selected from a cyclic aliphatic diglycidyl ether epoxy resin, a bisphenol A epoxy resin, and a bisphenol F epoxy resin.

The epoxy resin (B) preferably includes an epoxy resin having two or more epoxy groups in one molecule. The epoxy resin (B) preferably has an aromatic structure, and, in the case where the epoxy resin (B) includes two or more kinds of epoxy resins, at least one of the epoxy resins more preferably has an aromatic structure. The aromatic structure is a chemical structure generally defined as aromatic series, and includes polycyclic aromatic series and heteroaromatic rings. The ratio of an epoxy resin having two or more epoxy groups in one molecule is preferably 50% by mass or higher, more preferably 60% by mass or higher, and still more preferably 70% by mass or higher with respect to 100% by mass of non-volatile components of epoxy resins.

Epoxy resin includes an epoxy resin that remains liquid at a temperature of 25°C (hereinafter, sometimes referred to as "a liquid epoxy resin") and an epoxy resin that remains solid at a temperature of 25°C (hereinafter, sometimes referred to as "a solid epoxy resin"). The magnetic paste may contain a liquid epoxy resin only, may contain a solid epoxy resin only, or may contain a combination of a liquid epoxy resin and a solid epoxy resin, as the epoxy resin (B), but, from the viewpoint of lowering the viscosity of the magnetic paste, the magnetic paste preferably contains a liquid epoxy resin.

The liquid epoxy resin is preferably a glycyrol epoxy resin, a bisphenol A epoxy resin, a bisphenol F epoxy resin, a bisphenol AF epoxy resin, a naphthalene epoxy resin, a glycidyl ester epoxy resin, a glycidyl amine epoxy resin, a phenol novolac epoxy resin, a cycloaliphatic epoxy resin having an ester skeleton, a cyclohexanedimethanol epoxy resin, a cyclic aliphatic diglycidyl ether epoxy resin, a cyclic aliphatic glycidyl ether epoxy resin, a cyclic aliphatic glycidyl ether epoxy resin, or an epoxy resin having a butadiene structure, and is more preferably a bisphenol A epoxy resin, a bisphenol F epoxy resin, a cyclic aliphatic diglycidyl ether epoxy resin, or a cyclic aliphatic glycidyl ether epoxy resin. Specific examples of the liquid epoxy resin include HP4032, HP4032D, and HP4032SS (naphthalene epoxy resins), manufactured by DIC Corporation; 828US and jER828EL (bisphenol A epoxy resins), jER807 (a bisphenol F epoxy resin), and jER152 (a phenol novolac epoxy resin), manufactured by Mitsubishi Chemical Corporation; 630 and 630LSD, manufactured by Mitsubishi Chemical Corporation; ED-523T (a glycyrol epoxy resin (ADEKA GLYCIROL)), EP-3980S (a glycidyl amine epoxy resin), and EP-4088S (a dicyclopentadiene epoxy resin), manufactured by ADEKA Corporation; ZX1059 (a mixed product of a bisphenol A epoxy resin and a bisphenol F epoxy resin), EX-201 (a cyclic aliphatic glycidyl ether epoxy resin), and ZX1658 and ZX1658GS (cyclic aliphatic diglycidyl ether epoxy resins), manufactured by NIPPON STEEL Chemical & Material Co., Ltd.; EX-721 (a glycidyl ester epoxy resin), manufactured by Nagase ChemteX Corporation; Celloxide 2021P (a cycloaliphatic epoxy resin having an ester skeleton) and PB-3600 (an epoxy resin having a butadiene structure), manufactured by Daicel Corporation. These liquid epoxy resins may be used alone or two or more kinds thereof may be used in combination.

The solid epoxy resin is preferably a naphthalene tetrafunctional epoxy resin, a cresol novolac epoxy resin, a dicyclopentadiene epoxy resin, a trisphenol epoxy resin, a naphthol epoxy resin, a biphenyl epoxy resin, a naphthylene ether epoxy resin, an anthracene epoxy resin, a bisphenol A epoxy resin, or a tetraphenylethane epoxy resin, and more preferably a naphthalene tetrafunctional epoxy resin, a naphthol epoxy resin, or a biphenyl epoxy resin. Specific examples of the solid epoxy resin include HP4032H (a naphthalene epoxy resin), HP-4700 and HP-4710 (naphthalene tetrafunctional epoxy resins), N-690 (a cresol novolac epoxy resin), N-695 (a cresol novolac epoxy resin), HP-7200, HP-7200HH, and HP-7200H (dicyclopentadiene epoxy resins), EXA-7311, EXA-7311-G3, EXA-7311-G4, EXA-7311-G4S, and HP6000 (naphtylene ether epoxy resins), manufactured by DIC Corporation; EPPN-502H (a trisphenol epoxy resin), NC7000L (a naphthol novolac epoxy resin), NC3000H, NC3000, NC3000L, and NC3100 (biphenyl epoxy resins), manufactured by Nippon Kayaku Co., Ltd.; ESN475V (a naphthalene epoxy resin) and ESN485 (a naphthol novolac epoxy resin), manufactured by NIPPON STEEL Chemical & Material Co., Ltd.; YX4000H and YL6121 (biphenyl epoxy resins), YX4000HK (a bixylenol epoxy resin), and YX8800 (an anthracene epoxy resin), manufactured by Mitsubishi Chemical Corporation; PG-100 and CG-500, manufactured by Osaka Gas Chemicals Co., Ltd., and YL7760, manufactured by Mitsubishi Chemical Corporation (bisphenol AF epoxy resins), and YL7800 (a fluorene epoxy resin), jER1010 (a solid bisphenol A epoxy resin), and jER1031S (a tetraphenylethane epoxy resin), manufactured by Mitsubishi Chemical Corporation. These solid epoxy resins may be used alone or two or more kinds thereof may be used in combination.

When a liquid epoxy resin and a solid epoxy resin are used in combination as the epoxy resin (B), the mass ratio of these epoxy resins (liquid epoxy resin: solid epoxy resin) preferably falls within a range of 1:0.1 to 1:4. When the mass ratio of the liquid epoxy resin to the solid epoxy resin falls within the above-mentioned range, for example, the effect of achieving a cured product having sufficient breaking strength can be produced. From the viewpoint of the above-mentioned effect, the mass ratio of the liquid epoxy resin to the solid epoxy resin (liquid epoxy resin: solid epoxy resin) falls within preferably a range of 1:0.3 to 1:3.5, more preferably a range of 1:0.6 to 1:3, and still more preferably a range of 1:0.8 to 1:2.5.

From the viewpoint of achieving a magnetic layer excellent in mechanical strength, the content of the epoxy resin (B) is preferably 1% by mass or higher, more preferably 3% by mass or higher, still more preferably 5% by mass or higher, and still more preferably 10% by mass or higher, with respect to 100% by mass of non-volatile components in the magnetic paste. The upper limit of the content of the epoxy resin is not limited to a particular content as long as the effect of the present invention is achieved, but, is preferably 30% by mass or lower, more preferably 25% by mass or lower, and still more preferably 20% by mass or lower.

The content (% by volume) of the epoxy resin (B) is preferably 1% by volume or higher, more preferably 3% by volume or higher, and still more preferably 5% by volume or higher, with respect to 100% by volume of non-volatile components in the magnetic paste. The upper limit of the content of the epoxy resin is not limited to a particular content as long as the effect of the present invention is achieved, but, is preferably 25% by volume or lower, more preferably 20% by volume or lower, and still more preferably 15% by volume or lower.

The epoxy equivalent of the epoxy resin (B) is preferably 50 g/eq. to 5000 g/eq., more preferably 50 g/eq. to 3000 g/eq., still more preferably 80 g/eq. to 2000 g/eq., and still more preferably 110 g/eq. to 1000 g/eq. When the epoxy equivalent is within the above-mentioned range, the crosslinking density of the cured product is sufficient, whereby a magnetic layer having lower surface roughness can be offered. Note that the epoxy equivalent can be measured in accordance with JIS K7236, and is the mass of a resin containing one equivalent of epoxy group.

The weight-average molecular weight of the epoxy resin (B) is preferably 100 to 5000, more preferably 250 to 3000, and still more preferably 400 to 1500. Here, the weight-average molecular weight of the epoxy resin is a weight-average molecular weight in terms of polystyrene, measured by gel permeation chromatography (GPC).

### (C) Dispersant

The magnetic paste contains the dispersant (C) having a polyester skeleton represented by the following formula (1), as a component (C). 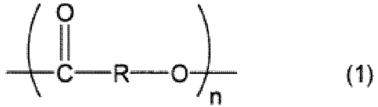 (In the formula (1), R is independently a divalent hydrocarbon group having 2 to 10 carbon atoms, and n is an integer of 2 to 1,000.)

As described above, a higher content of the magnetic powder (A) causes an increase in the viscosity of magnetic paste, and in addition, a decrease in the mechanical strength of a cured product of the magnetic paste. In the present invention, the magnetic paste contains the component (C) as a dispersant, so that a lower viscosity can be achieved, compared with a paste not containing the component (C) (in other words, a paste having the same composition as that of the magnetic paste, except that the paste does not contain the component (C)). Thus, even when the content of the magnetic powder (A) is high, the viscosity of the magnetic paste can be inhibited from increasing, and furthermore the mechanical strength of a cured product of the magnetic paste can be enhanced.

The component (C) has a polyester skeleton represented by the formula (1). 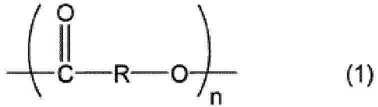 (In the formula (1), R is independently a divalent hydrocarbon group having 2 to 10 carbon atoms, and n is an integer of 2 to 1,000.)

R in the formula (1) is a divalent hydrocarbon group having 2 to 10 carbon atoms. The number of carbon atoms of the hydrocarbon group is 2 or more, preferably 3 or more, and more preferably 4 or more. The upper limit of the number of carbon atoms is 10 or less, preferably 8 or less, and more preferably 6 or less. The hydrocarbon group may be a linear, branched, or cyclic hydrocarbon group, and preferably a linear or branched hydrocarbon group. Examples of the hydrocarbon group include an aliphatic hydrocarbon group and an aromatic hydrocarbon group, and the hydrocarbon group is preferably an aliphatic hydrocarbon group. Specific examples of the hydrocarbon group include an alkylene group, an alkenylene group, an alkynylene group, and an arylene group. In particular, from the viewpoint of remarkably achieving the effect of the present invention, the hydrocarbon group is preferably an alkylene group.

Examples of the alkylene group include an ethylene group, a propylene group, a butylene group, a pentylene group, a hexylene group, a heptylene group, an octylene group, a nonylene group, and a decylene group. Examples of the alkenylene group include an ethenylene group, a propenylene group, a butenylene group, a pentenylene group, a hexenylene group, a heptenylene group, an octenylene group, a nonenylene group, and a decenylene group. Examples of the alkynylene group include an ethynylene group, a propynylene group, a butynylene group, a pentynylene group, a hexynylene group, a heptynylene group, an octynylene group, a nonynylene group, and a decynylene group. Examples of the arylene group include a phenylene group and a naphtylene group. In particular, R is preferably a butylene group or a pentylene group.

The divalent hydrocarbon group represented by R in the formula (1) may or may not have a substituent. The substituent is not limited to a particular one, and examples thereof include a halogen atom, -OH, -O-C₁₋₆ alkyl group, -N(C₁₋₁₀ alkyl group)₂, C₁₋₁₀ alkyl group, C₆₋₁₀ aryl group, -NH₂, -CN, -C(O)O-C₁₋₁₀ alkyl group, -COOH, -C(O)H, and -NO₂. Here, the term "C_{p-q}" (p and q are positive integers, and p < q is satisfied) denotes that the number of carbon atoms of an organic group indicated just behind this term is p to q. For example, the term "a C₁₋₁₀ alkyl group" indicates an alkyl group having 1 to 10 carbon atoms. These substituents may bind to each other to form a ring. Examples of the ring structure include a spiro ring and a condensed ring.

The above-mentioned substituent may further have a substituent (hereinafter, sometimes referred to as "a secondary substituent"). As the secondary substituent, the above-mentioned substituents may be used, unless otherwise specified.

n in the formula (1) is an integer of 2 to 1,000. n is 2 or more, preferably 5 or more, and more preferably 10 or more. The upper limit of n is 1,000 or less, preferably 500 or less, more preferably 100 or less, and still more preferably 50 or less.

The component (C) may contain an optional skeleton in addition to the polyester skeleton represented by the formula (1), unless the effect of the present invention is inhibited. Examples of the optional skeleton include a polyester skeleton in which R in the formula (1) is a divalent hydrocarbon group having 1 or 11 or more carbon atoms (n is the same as that in the formula (1)), and a polyallylamine skeleton. For example, an end of the polyester skeleton is not particularly limited.

Examples of the end of the component (C) include the later-mentioned carboxylic acid residue, a hydroxy group, and a hydrogen atom.

The component (C) having a polyester skeleton represented by the formula (1) can be produced, for example, by allowing lactone represented by a formula (2) to react with a carboxylic acid. 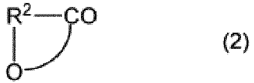 (R² in the formula (2) is the same as R in the formula (1).)

Examples of the lactone represented by the formula (2) include ε-caprolactone, β-propiolactone, γ-butyrolactone, δ-valerolactone, β-methyl-δ-valerolactone, 4-methyl caprolactone, and 2-methyl caprolactone.

As the carboxylic acid, a carboxylic acid that functions as an initiator for the ring-opening polymerization of the lactone represented by the formula (2) can be used. Examples of such carboxylic acid include hydroxycarboxylic acids, such as ricinoleic acid, ricinoleic acid, 9-hydroxystearic acid, 10-hydroxystearic acid, castor oil fatty acid, hydrogenated castor oil fatty acid, lactic acid, 12-hydroxystearic acid, and glycolic acid; dodecanoic acids; and stearic acids. Among them, hydroxycarboxylic acids are preferably used from the viewpoint of remarkably achieving the effect of the present invention.

The temperature of the reaction is preferably 120°C to 220°C, and more preferably 160°C to 210°C. The time of the reaction is preferably 0.5 hour to 72 hours. When the reaction is conducted in a nitrogen gas stream, polyester with a high degree of polymerization can be obtained.

For the above-mentioned reaction, a polymerization catalyst or a polymerization initiator may be used, as needed, from the viewpoint of controlling the reaction.

Examples of the polymerization catalyst include quaternary ammonium salts, such as tetramethylammonium chloride, tetrabutylammonium chloride, tetramethylammonium bromide, tetrabutylammonium bromidetetramethylammonium iodide, tetrabutylammonium iodide, benzyltrimethylammonium chloride, benzyltrimethylammonium bromide, and benzyltrimethylammonium iodide; quaternary phosphonium salts, such as tetramethylphosphonium chloride, tetrabutylphosphonium chloride, tetramethylphosphonium bromide, tetrabutylphosphonium bromide, tetramethylphosphonium iodide, tetrabutylphosphonium iodide, benzyltrimethylphosphonium chloride, benzyltrimethylphosphonium bromide, benzyltrimethylphosphonium iodide, tetraphenylphosphonium chloride, tetraphenylphosphonium bromide, and tetraphenylphosphonium iodide; phosphorus compounds, such as triphenylphosphine; organic carboxylates, such as potassium acetate, sodium acetate, potassium benzoate, and sodium benzoate; alkali metal alcoholate, such as sodium alcoholate and potassium alcoholate; tertiary amines; organnotin compounds; organoaluminum compounds; organotitanate compounds, such as tetrabutyl titanate; and zinc compounds, such as zinc chloride.

Examples of the polymerization initiator include monocarboxylic acids, such as aliphatic monocarboxylic acids, such as acetic acid, propionic acid, caprylic acid, nonanoic acid, capric acid, octylic acid, lauryl acid, myristic acid, palmitic acid, stearic acid, isononanoic acid, and arachic acid; and aromatic monocarboxylic acids, such as benzoic acid and p-butylbenzoic acid.

For the production of the component (C), an optional monomer may be used in addition to the lactone represented by the formula (2) and the carboxylic acid, unless the effect of the present invention is inhibited. Examples of the optional monomer include polyallylamine. For example, when polyallylamine is used as the optional monomer, the component (C) having not only the polyester skeleton represented by the formula (1) but also a polyallylamine skeleton can be produced. The temperature of the reaction and the time of the reaction are the same as the temperature of the reaction and the time of the reaction for the production of the component (C) having the polyester skeleton represented by the formula (1).

The polyallylamine can be obtained by the polymerization of allylamines in the presence of a polymerization initiator and/or a chain transfer catalyst.

The polymerization initiator is not limited to a particular one, and examples thereof may include ketone peroxides, such as methyl ethyl ketone; diacyl peroxides, such as benzoyl peroxide; peroxy carbonates, such as diisopropylperoxy dicarbonate; peroxy ketals, such as 1,1-bis(t-butylperoxy)cyclohexane; hydroperoxides, such as t-butyl hydroperoxide; peroxy esters, such as t-butyl peroxypivalate; and others, such as azobisisobutyronitrile, hydrogen peroxide, and a ferrous salt. Furthermore, a polymerization initiator described in Japanese Examined Patent Publication No. H2-14364 may be used. These polymerization initiators may be used alone, or two or more kinds thereof may be used in combination.

The chain transfer catalyst is not limited to a particular one, and examples thereof include alkyl mercaptans, such as lauryl mercaptan; thiocarboxylic acids, such as mercaptoacetic acid, 2-mercaptopropionic acid, and 3-mercaptopropionic acid; and thiocarboxylic acid esters, such as butyl thioglycolate and 2-ethylhexyl thioglycolate. These chain transfer catalysts may be used alone, or two or more kinds thereof may be used in combination.

The weight-average molecular weight of the polyallylamine is preferably 150 to 100,000, and more preferably 600 to 20,000. When the weight-average molecular weight of the polyallylamine is 150 or higher, adsorbability onto particles of the component (A) and the like is enhanced, so that particle dispersibility is enhanced. On the other hand, when the weight-average molecular weight of the polyallylamine is 100,000 or lower, aggregation of particles can be substantially prevented, so that particle dispersibility is enhanced. Note that, using a method described in Japanese Examined Patent Publication No. H2-14364, polyallylamine having any weight-average molecular weight may be produced.

Commercially available polyallylamine can be used.
Examples of the commercially available polyallylamine include PAA-01, PAA-03, PAA-05, PAA-08, PAA-15, PAA-15C, and PAA-25, manufactured by NITTOBO MEDICAL CO., LTD.

The pH of the component (C) in the present invention can be typically 4 or higher and lower than 7. The pH can be measured using an indicator method. Specifically, the pH can be measured in such a manner that a measurement sample (22°C) prepared by dissolving a dispersant in acetone and having a dispersant concentration of 0.1 g/mL is dipped in a pH test paper. As the pH test paper, a pH test paper capable of measuring a pH in an acidic region (for example, a pH test paper capable of measuring a pH of 0.0 to 14.0, a pH of 1.0 to 14.0, or a pH of 0.5 to 5.0) can be used, and examples thereof include a pH test paper, namely, pH Test Paper pH 1 to 14 (pH measurement range: pH 1.0 to 14.0), manufactured by AS ONE CORPORATION.

From the viewpoint of remarkably achieving the effect of the present invention, the acid value of the component (C) is preferably 1 mg KOH/g or more, more preferably 3 mg KOH/g or more, and still more preferably 5 mg KOH/g or more, and preferably 30 mg KOH/g or less, more preferably 25 mg KOH/g or less, and still more preferably 20 mg KOH/g or less. The acid value can be measured by neutralization titration.

In the case where the component (C) is a dispersant obtained by reaction with polyallylamine, the amine value of the component (C) is preferably 1 mg KOH/g or more, more preferably 5 mg KOH/g or more, and still more preferably 10 mg KOH/g or more, and preferably 45 mg KOH/g or less, more preferably 40 mg KOH/g or less, and still more preferably 35 mg KOH/g or less, from the viewpoint of remarkably achieving the effect of the present invention. The amine value can be measured by neutralization titration.

From the viewpoint of remarkably achieving the effect of the present invention, the weight-average molecular weight of the component (C) is preferably 2,000 or higher, more preferably 3,000 or higher, and still more preferably 5,000 or higher, and preferably 50,000 or lower, more preferably 40,000 or lower, and still more preferably 30,000 or lower. The weight average molecular weight is a weight-average molecular weight in terms of polystyrene, measured by gel permeation chromatography (GPC).

From the viewpoint of remarkably exhibiting the effects of the present invention, the content of the component (C) is preferably 0.1% by mass or higher, more preferably 0.3% by mass or higher, and still more preferably 0.5% by mass or higher, with respect to 100% by mass of non-volatile components in the magnetic paste. The upper limit of the content is preferably 5% by mass or lower, more preferably 4% by mass or lower, and still more preferably 3% by mass or lower.

When the mass of the component (C) is taken as C1 with respect to 100% by mass of non-volatile components in the magnetic paste and the mass of the magnetic powder (A) is taken as A1 with respect to 100% by mass of the non-volatile components in the magnetic paste, (C1/A1) × 100 is preferably 0.1 or more, more preferably 0.3 or more, and still more preferably 0.5 or more, and preferably 10 or less, more preferably 5 or less, and still more preferably 1 or less. The masses of the components (A) and (C) are adjusted so as to achieve (C1/A1) × 100 within the above-mentioned range, whereby the desired effects of the present invention can be more remarkably achieved.

### (D) Curing agent

The magnetic paste contains the curing agent (D). The curing agent (D) includes an epoxy resin curing agent having the function of curing the epoxy resin (B) and a curing accelerator having the function of accelerating the curing rate of the epoxy resin (B). The magnetic paste preferably contains the epoxy resin curing agent as the curing agent (D). The magnetic paste may contain the curing accelerator as well as the epoxy resin curing agent, as the curing agent (D). The curing accelerator is usually used together with the epoxy resin curing agent.

### Epoxy resin curing agent

An epoxy resin curing agent can typically react with epoxy resin to cure the magnetic paste. Examples of the epoxy resin curing agent include a phenol-based epoxy resin curing agent, a naphthol-based epoxy resin curing agent, an active ester-based epoxy resin curing agent, an acid anhydride-based epoxy resin curing agent, a benzoxazine-based epoxy resin curing agent, a cyanate ester-based epoxy resin curing agent, and an imidazole-based epoxy resin curing agent. From the viewpoint of lowering the viscosity of the magnetic paste, the epoxy resin curing agent is preferably an acid anhydride-based epoxy resin curing agent or an imidazole-based epoxy resin curing agent. Furthermore, from the viewpoint of enhancing the mechanical strength of a cured product to be obtained, the epoxy resin curing agent is more preferably an imidazole-based epoxy resin curing agent. The epoxy resin curing agent may be used alone or two or more kinds thereof may be used in combination.

From the viewpoints of heat-resistance and water-resistance, the phenol-based epoxy resin curing agent and the naphthol-based epoxy resin curing agent are preferably a phenol-based epoxy resin curing agent having a novolac structure and a naphthol-based epoxy resin curing agent having a novolac structure, respectively. The phenol-based epoxy resin curing agent is preferably a nitrogen-containing phenol-based epoxy resin curing agent, more preferably a triazine skeleton-containing phenol-based epoxy resin curing agent, and still more preferably a triazine skeleton-containing phenol novolac epoxy resin curing agent.

Specific examples of the phenol-based epoxy resin curing agent and the naphthol-based epoxy resin curing agent include MEH-7700, MEH-7810, and MEH-7851, manufactured by Meiwa Plastic Industries, Ltd.; NHN, CBN, and GPH, manufactured by Nippon Kayaku Co., Ltd.; SN170, SN180, SN190, SN475, SN485, SN495V, SN375, and SN395, manufactured by Nippon Steel & Sumikin Chemical Co., Ltd.; TD-2090, LA-7052, LA-7054, LA-1356, LA-3018-50P, EXB-9500, HPC-9500, KA-1160, KA-1163, and KA-1165, manufactured by DIC Corporation; and GDP-6115L and GDP-6115H, manufactured by Gun Ei Chemical Industry Co., Ltd.

The active ester-based epoxy resin curing agent is, but not particularly limited to, generally preferably a compound having two or more highly reactive ester groups in one molecule, such as phenol esters, thiophenol esters, N-hydroxyamine esters, and esters of heterocyclic hydroxy compounds. The active ester-based epoxy resin curing agent is preferably obtained by a condensation reaction of a carboxylic acid compound and/or a thiocarboxylic acid compound with a hydroxy compound and/or a thiol compound. In particular, from the viewpoint of enhancing heat resistance, the active ester-based epoxy resin curing agent is preferably an active ester-based epoxy resin curing agent obtained from a carboxylic acid compound and a hydroxy compound, and more preferably an active ester-based epoxy resin curing agent obtained from a carboxylic acid compound and a phenol compound and/or a naphthol compound. Examples of the carboxylic acid compound include benzoic acid, acetic acid, succinic acid, maleic acid, itaconic acid, phthalic acid, isophthalic acid, terephthalic acid, and pyromellitic acid. Examples of the phenol compound and the naphthol compound include hydroquinone, resorcinol, bisphenol A, bisphenol F, bisphenol S, phenolphthalin, methylated bisphenol A, methylated bisphenol F, methylated bisphenol S, phenol, o-cresol, m-cresol, p-cresol, catechol, α-naphthol, β-naphthol, 1,5-dihydroxynaphthalene, 1,6-dihydroxynaphthalene, 2,6-dihydroxynaphthalene, dihydroxybenzophenone, trihydroxybenzophenone, tetrahydroxybenzophenone, phloroglucin, benzenetriol, a dicyclopentadiene diphenol compound, and phenol novolac. Here, the term "dicyclopentadiene diphenol compound" is a diphenol compound obtained by condensation of two molecules of phenol and one molecule of dicyclopentadiene.

Specifically, an active ester-based epoxy resin curing agent having a dicyclopentadiene diphenol structure, an active ester-based epoxy resin curing agent having a naphthalene structure, an active ester-based epoxy resin curing agent containing acetylated phenol novolac, and an active ester-based epoxy resin curing agent containing benzoylated phenol novolac are preferably used. The term "dicyclopentadiene diphenol structure" is a divalent structure composed of phenylene-dicyclopentylene-phenylene.

Examples of a commercially available active ester-based epoxy resin curing agent include EXB9451, EXB9460, EXB9460S, HPC-8000-65T, HPC-8000H-65TM, and EXB-8000L-65TM, manufactured by DIC Corporation, as the active ester-based epoxy resin curing agent having a dicyclopentadiene diphenol structure; EXB9416-70BK, manufactured by DIC Corporation, as the active ester compound having a naphthalene structure; DC808, manufactured by Mitsubishi Chemical Corporation, as the active ester-based epoxy resin curing agent containing acetylated phenol novolac; YLH1026, YLH1030, and YLH1048, manufactured by Mitsubishi Chemical Corporation, as the active ester-based epoxy resin curing agent containing benzoylated phenol novolac; and DC808, manufactured by Mitsubishi Chemical Corporation, as the active ester-based epoxy resin curing agent containing acetylated phenol novolac.

Examples of the acid anhydride-based epoxy resin curing agent include an epoxy resin curing agent having one or more acid anhydride groups in one molecule. Specific example of the acid anhydride-based epoxy resin curing agent include phthalic anhydride, tetrahydrophthalic anhydride, hexahydrophthalic anhydride, methyltetrahydrophthalic anhydride, methylhexahydrophthalic anhydride, methyl nadic anhydride, hydrogenated methyl nadic anhydride, trialkyltetrahydrophthalic anhydride, dodecenyl succinic anhydride, 5-(2,5-dioxotetrahydro-3-furanyl)-3-methyl-3-cyclohexene-1,2-dicarboxylic anhydride, trimellitic anhydride, pyromellitic anhydride, benzophenone tetracarboxylic dianhydride, biphenyl tetracarboxylic dianhydride, naphthalene tetracarboxylic dianhydride, oxydiphthalic dianhydride, 3,3'-4,4'-diphenylsulfone tetracarboxylic dianhydride, 1,3,3a,4,5,9b-hexahydro-5-(tetrahydro-2,5-dioxo-3-furanyl)-naphto[1,2-C]furan-1,3-dione, ethylene glycol bis(anhydrotrimellitate), and an acid anhydride polymer such as a styrene-maleic acid resin obtained by copolymerization of styrene and maleic acid.

Examples of a commercially available acid anhydride-based epoxy resin curing agent include HNA-100 and MH-700, manufactured by New Japan Chemical Co., Ltd.

Specific examples of the benzoxazine-based epoxy resin curing agent include HFB2006M, manufactured by Showa Highpolymer Co., Ltd., and P-d and F-a, manufactured by SHIKOKU CHEMICALS CORPORATION.

Examples of the cyanate ester-based epoxy resin curing agent include difunctional cyanate resins, such as bisphenol A dicyanate, polyphenol cyanate, oligo(3-methylene-1,5-phenylenecyanate), 4,4'-methylenebis(2,6-dimethylphenyl cyanate), 4,4'-ethylidenediphenyl dicyanate, hexafluorobisphenol A dicyanate, 2,2-bis(4-cyanate)phenylpropane, 1,1-bis(4-cyanatephenylmethane), bis(4-cyanate-3,5-dimethylphenyl)methane, 1,3-bis(4-cyanatephenyl-1-(methylethylidene))benzene, bis(4-cyanatephenyl)thioether, and bis(4-cyanatephenyl)ether; polyfunctional cyanate resins derived from, for example, phenol novolac and cresol novolac; and prepolymers in which these cyanate esters are partially triazinized. Specific examples of the cyanate ester-based epoxy resin curing agent include PT30 and PT60 (both are phenol novolac polyfunctional cyanate ester resins) and BA230 and BA230S75 (prepolymers in which bisphenol A dicyanate is partially or entirely triazinized to form a trimer), manufactured by Lonza Japan Ltd.

Examples of the imidazole-based epoxy resin curing agent include imidazole compounds, such as 2-methylimidazole, 2-undecylimidazole, 2-heptadecylimidazole, 1,2-dimethylimidazole, 2-ethyl-4-methylimidazole, 1,2-dimethylimidazole, 2-ethyl-4-methylimidazole, 2-phenylimidazole, 2-phenyl-4-methylimidazole, 1-benzyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-methylimidazolyl-(1')]-ethyl-s-triazine, a 2,4-diamino-6-[2'-methylimidazolyl-(1')]-ethyl-s-triazine isocyanuric acid adduct, a 2-phenylimidazole isocyanuric acid adduct, 2-phenyl-4,5-dihydroxymethylimidazole, 2-phenyl-4-methyl-5-hydroxymethylimidazole, 2,3-dihydro-1H-pyrrolo[1,2-a]benzimidazole, 1-dodecyl-2-methyl-3-benzylimidazolium chloride, 2-methylimidazoline, and 2-phenylimidazoline; and an adduct of an imidazole compound and an epoxy resin. The imidazole-based epoxy resin curing agent is preferably 2-ethyl-4-methylimidazole or 1-benzyl-2-phenylimidazole.

As the imidazole-based epoxy resin curing agent, a commercially available imidazole-based epoxy resin curing agent may be used, and examples thereof include 2MZA-PW and 2PHZ-PW, manufactured by SHIKOKU CHEMICALS CORPORATION, and P200-H50, manufactured by Mitsubishi Chemical Corporation.

The amount ratio of an epoxy resin to an epoxy resin curing agent is the ratio of [the total number of epoxy groups in the epoxy resin] : [the total number of reactive groups in the epoxy resin curing agent], and is preferably in a range of 1:0.2 to 1:2, more preferably in a range of 1:0.3 to 1:1.5, and still more preferably in a range of 1:0.4 to 1:1. Here, the reaction groups of the epoxy resin curing agent are, for example, an active hydroxyl group and an active ester group, and are different depending on the kind of the epoxy resin curing agent. The total number of epoxy groups in the epoxy resin is a value obtained by dividing the mass of non-volatile components in the epoxy resins by respective epoxy equivalents and summing the resulting values for all the epoxy resins. The total number of reactive groups in the epoxy resin curing agent is a value obtained by dividing the mass of non-volatile components in the epoxy resin curing agents by respective reactive group equivalents and summing the resulting values for all the epoxy resin curing agents. When the amount ratio of the epoxy resin to the epoxy resin curing agent is in the above-mentioned range, a resulting cured product has higher heat-resistance.

### Curing accelerator

A curing accelerator can typically act as a catalyst for the curing reaction of epoxy resin to accelerate a curing reaction. Examples of the curing accelerator include an amine-based curing accelerator, an imidazole-based curing accelerator, a phosphorus-based curing accelerator, a guanidine-based curing accelerator, and a metal-based curing accelerator. From the viewpoint of lowering the viscosity of the magnetic paste, the curing accelerator is preferably an amine-based curing accelerator, an imidazole-based curing accelerator, or a guanidine-based curing accelerator. Furthermore, from the viewpoint of enhancing the mechanical strength of a cured product to be obtained, the curing accelerator is more preferably an imidazole-based curing accelerator. The curing accelerator may be used alone, or two or more kinds thereof may be used in combination. The curing accelerator is typically used together with the epoxy resin curing agent.

Examples of the amine-based curing accelerator include trialkylamines such as triethylamine and tributylamine, 4-dimethylaminopyridine, benzyldimethylamine, 2,4,6-tris(dimethylaminomethyl)phenol, and 1,8-diazabicyclo(5,4,0)-undecene. The amine-based curing accelerator is preferably 4-dimethylaminopyridine or 1,8-diazabicyclo(5,4,0)-undecene.

As the amine-based curing accelerator, a commercially available amine-based curing accelerator may be used, and examples thereof include PN-50, PN-23, and MY-25, manufactured by Ajinomoto Fine-Techno Co., Inc.

The imidazole-based curing accelerator is the same as the above-mentioned imidazole-based epoxy resin curing agent. The above-mentioned imidazole-based epoxy resin curing agent sometimes functions as a curing accelerator when used together with another epoxy resin curing agent.

Examples of the phosphorus-based curing accelerator include triphenylphosphine, a phosphonium borate compound, tetraphenylphosphonium tetraphenylborate, n-butylphosphonium tetraphenylborate, tetrabutylphosphonium decanoate, (4-methylphenyl)triphenylphosphonium thiocyanate, tetraphenylphosphonium thiocyanate, and butyltriphenylphosphonium thiocyanate. The phosphorus-based curing accelerator is preferably triphenylphosphine or tetrabutylphosphonium decanoate.

Examples of the guanidine-based curing accelerator include dicyandiamide, 1-methylguanidine, 1-ethylguanidine, 1-cyclohexylguanidine, 1-phenylguanidine, 1-(o-tolyl)guanidine, dimethylguanidine, diphenylguanidine, trimethylguanidine, tetramethylguanidine, pentamethylguanidine, 1,5,7-triazabicyclo[4.4.0]dec-5-ene, 7-methyl-1,5,7-triazabicyclo[4.4.0]dec-5-ene, 1-methylbiguanide, 1-ethylbiguanide, 1-n-butylbiguanide, 1-n-octadecylbiguanide, 1,1-dimethylbiguanide, 1,1-diethylbiguanide, 1-cyclohexylbiguanide, 1-allylbiguanide, 1-phenylbiguanide, and 1-(o-tolyl)biguanide. The guanidine-based curing accelerator is preferably dicyandiamide or 1,5,7-triazabicyclo[4.4.0]dec-5-ene.

Examples of the metal-based curing accelerator include organic metal complexes and organic metal salts of metals such as cobalt, copper, zinc, iron, nickel, manganese, and tin. Specific examples of the organic metal complex include organic cobalt complexes, such as cobalt (II) acetylacetonate and cobalt (III) acetylacetonate, an organic copper complex such as copper (II) acetylacetonate, an organic zinc complex such as zinc (II) acetylacetonate, an organic iron complex such as iron (III) acetylacetonate, an organic nickel complex such as nickel (II) acetylacetonate, and an organic manganese complex such as manganese (II) acetylacetonate. Examples of the organic metal salt include zinc octoate, tin octoate, zinc naphthenate, cobalt naphthenate, tin stearate, and zinc stearate.

From the viewpoints of lowering the viscosity of the magnetic paste and enhancing the viscosity pot life thereof, the content of the curing agent (D) is preferably 0.1% by mass or higher, more preferably 0.3% by mass or higher, and still more preferably 0.5% by mass or higher, with respect to 100% by mass of non-volatile components in the magnetic paste. Furthermore, the upper limit of the content is preferably 5% by mass or lower, more preferably 3% by mass or lower, and still more preferably 1% by mass or lower.

When the mass of the curing agent (D) is taken as D1 with respect to 100% by mass of non-volatile components in the magnetic paste and the mass of the dispersant (C) is taken as C1 with respect to 100% by mass of the non-volatile components in the magnetic paste, C1/D1 is preferably 0.1 or more, more preferably 0.15 or more, and still more preferably 0.2 or more, and preferably 5 or less, more preferably 3 or less, and still more preferably 2.5 or less. The masses of the components (C) and (D) are adjusted so as to achieve C1/D1 within the above-mentioned range, whereby the desired effects of the present invention can be more remarkably achieved.

When the mass of the magnetic powder (A) is taken as A1 with respect to 100% by mass of the non-volatile components in the magnetic paste, the mass of the epoxy resin (B) is taken as B1 with respect to 100% by mass of the non-volatile components in the magnetic paste, the mass of the dispersant (C) is taken as C1 with respect to 100% by mass of the non-volatile components in the magnetic paste, and the mass of the curing agent (D) is taken as D1 with respect to 100% by mass of the non-volatile components in the magnetic paste, (B1+C1+D1)/A1 is preferably 0.01 or more, more preferably 0.05 or more, and still more preferably 0.1 or more, and preferably 1 or less, more preferably 0.5 or less, and still more preferably 0.3 or less. The masses of the components (A) to (D) are adjusted so as to achieve (B1+C1+D1)/A1 within the above-mentioned range, whereby the desired effects of the present invention can be more remarkably achieved.

When the mass of the magnetic powder (A) is taken as A1 with respect to 100% by mass of the non-volatile components in the magnetic paste, the mass of the dispersant (C) is taken as C1 with respect to 100% by mass of the non-volatile components in the magnetic paste, and the mass of the curing agent (D) is taken as D1 with respect to 100% by mass of the non-volatile components in the magnetic paste, ((C1+D1)/A1) × 100 is preferably 0.1 or more, more preferably 0.5 or more, and still more preferably 1 or more, and preferably 10 or less, more preferably 5 or less, and still more preferably 3 or less. The masses of the components (A), (C), and (D) are adjusted so as to achieve ((C1+D1)/A1) × 100 within the above-mentioned range, whereby the desired effects of the present invention can be more remarkably achieved.

### (E) Other additives

The magnetic paste may further contain other additives (E), if needed. Examples of the other additives include a curing retardant, such as triethyl borate; an inorganic filler (except an inorganic filler equivalent to the magnetic powder); a thermoplastic resin; a fire retardant; an organic filler; organometallic compounds, such as an organocopper compound, an organozinc compound, and an organocobalt compound; and resin additives, such as a thickener, a defoaming agent, a leveling agent, an adhesion imparting agent, and a colorant.

The content of the above-mentioned organic solvent in the magnetic paste is preferably less than 1.0% by mass, more preferably 0.8% by mass or lower, still more preferably 0.5% by mass or lower, and particularly preferably 0.1% by mass or lower, with respect to the total mass of the magnetic paste. The lower limit of the content of the organic solvent is not particularly limited, but is 0.001% by mass or higher, or alternatively the magnetic paste does not contain the organic solvent. Even the magnetic paste does not contain any organic solvent, the viscosity of the magnetic paste can be made lower. When the magnetic paste contains the organic solvent in smaller amounts, occurrence of a void due to volatilization of the organic solvent can be prevented.

### Method for producing magnetic paste

The magnetic paste can be produced, for example, by stirring blending components with a stirrer, such as a three-roll mill or a rotary mixer.

Physical properties and other properties of magnetic paste

The magnetic paste has the property of having a low viscosity. Hence, the magnetic paste is excellent in printability. The viscosity at 25°C of the magnetic paste is preferably 300 Pa·s or lower, more preferably 250 Pa·s or lower, and still more preferably lower than 200 Pa·s, and preferably 10 Pa·s or higher, more preferably 20 Pa·s or higher, and still more preferably 30 Pa·s or higher. The viscosity can be measured using, for example, an E-type viscometer (RE-80U, manufactured by TOKI SANGYO CO., LTD.), and the measurement can be performed by a method described in detail in the later-mentioned examples.

A cured product obtained by heating the magnetic paste at 180°C for 90 minutes typically has the property of being excellent in mechanical strength (tensile break strength). Accordingly, the cured product brings about a magnetic layer excellent in tensile break strength. The tensile break strength is preferably 50 MPa or higher, more preferably 60 MPa or higher, and still more preferably 70 MPa or higher. The upper limit of the tensile break strength is not particularly limited, but may be 100 MPa or lower, for example. The tensile break strength can be measured by a method described in the later-mentioned examples.

The cured product obtained by heating the magnetic paste at 180°C for 90 minutes has the property of having a higher relative magnetic permeability at a frequency of 100 MHz. Accordingly, the above-mentioned cured product brings about a magnetic layer having a higher relative magnetic permeability. The relative magnetic permeability of this cured product at a frequency of 100 MHz is preferably 1 or more, more preferably 3 or more, and still more preferably 7 or more. The upper limit of relative magnetic permeability is not particularly limited, but can be 20 or less, for example. The relative magnetic permeability can be measured by a method described in examples mentioned later.

The cured product obtained by heating the magnetic paste at 180°C for 90 minutes typically has the property of having a smaller magnetic loss at a frequency of 100 MHz. Accordingly, the above-mentioned cured product brings about a magnetic layer having a smaller magnetic loss. The magnetic loss of this cured product at a frequency of 100 MHz is preferably 1 or less, more preferably 0.5 or less, and still more preferably 0.3 or less. The lower limit of the magnetic loss is not particularly limited, but may be 0.001 or more, for example. The magnetic loss can be measured by a method described in examples mentioned later.

### Resin Composition

The aforementioned magnetic paste may have states other than pasty state. For example, the magnetic paste may have states other than pasty state during storage or transportation. Thus it is possible to obtain a resin composition of the present invention whose state is not limited. The resin composition usually has the same features, effects and use as the aforementioned magnetic paste. Specifically, the resin composition may comprise the magnetic powder (A), the epoxy resin (B), the dispersant (C), and the curing agent (D). The resin composition may be the same composition as the aforementioned magnetic paste except that the resin composition may have states other than pasty state.

### Cured product

A cured product of the present invention can be obtained by curing the magnetic paste of the present invention, and a cured product of the present invention can be obtained by curing the resin composition of the present invention. As conditions for curing the magnetic paste and the resin composition, conditions at the later mentioned process (2) may be used. Furthermore, before heat-cured, the magnetic paste and the resin composition may be preheated, and may be subjected to heating two or more times including the preheating.

### Magnetic sheet

A magnetic sheet includes: a support; and a resin composition layer provided on the support and formed of the magnetic paste. A magnetic sheet includes: a support; and a resin composition layer provided on the support and formed of the resin composition.

From the viewpoint of slimming down, the thickness of the resin composition layer is preferably 250 um or less, more preferably 200 um or less, still more preferably 150 um or less, still more preferably 100 um or less. The lower limit of the thickness of the resin composition layer is not particularly limited, but may be usually 5 um or more, for example.

Examples of the support include a film made of a plastic material, a metal foil, and release paper. A film made of a plastic material and a metal foil are preferably used.

In the case where a film made of a plastic material is used as the support, examples of the plastic material include polyesters, such as polyethylene terephthalate (hereinafter, sometimes referred to as "PET") and polyethylenenaphthalate (hereinafter, sometimes referred to as "PEN"), polycarbonate (hereinafter, sometimes referred to as "PC"), acrylic such as polymethylmethacrylate (PMMA), cyclic polyolefin, triacetyl cellulose (TAC), polyether sulfide (PES), polyether ketone, and polyimide. Among them, polyethylene terephthalate and polyethylene naphthalate are preferably used, and polyethylene terephthalate, which is inexpensive, is particularly preferably used.

In the case where a metal foil is used as the support, examples of the metal foil include copper foil and aluminum foil, and copper foil is preferably used. As the copper foil, a foil made of a single metal of copper may be used, or alternatively a foil made of an alloy of copper and another metal (for example, tin, chromium, silver, magnesium, nickel, zirconium, silicon, or titanium) may be used.

A surface of the support to be joined to the resin composition layer may be subjected to mat treatment or corona treatment.

As the support, use may be made of a support provided with a mold release layer, the support having the mold release layer on a surface to be joined to the resin composition layer. Examples of a mold release agent used for the mold release layer of the support provided with the mold release layer include one or more mold release agents selected from the group consisting of alkyd resin, polyolefin resin, urethane resin, and silicone resin. As the support provided with the mold release layer, a commercially available one may be used, and examples thereof include PET films having a mold release layer containing an alkyd resin-based mold release agent as a principal component, such as SK-1, AL-5, and AL-7, manufactured by LINTEC Corporation; Lumirror T60, manufactured by Toray Industries, Inc.; Purex, manufactured by TEIJIN LIMITED; and Unipeel, manufactured by UNITIKA LTD.

The thickness of the support is not particularly limited, but may be preferably in a range of 5 um to 75 um, and more preferably in a range of 10 um to 60 um. Note that, in the case where the support provided with the mold release layer is used, the thickness of the entirety of the support provided with the mold release layer is preferably in the above-mentioned range.

The magnetic sheet can be manufactured by, for example, preparing resin varnish by dissolving the magnetic paste in an organic solvent, and applying this resin varnish onto the support by a die coater or the like, and furthermore drying the resin varnish to form a resin composition layer. Alternatively, the magnetic sheet can be manufactured by applying the magnetic paste directly onto the support by a die coater to form a resin composition layer.

Examples of the organic solvent may include ketones, such as acetone, methyl ethyl ketone (MEK), and cyclohexanone; acetate esters, such as ethyl acetate, butyl acetate, cellosolve acetate, propylenegylcol monomethyl ether acetate, and carbitol acetate; carbitols, such as cellosolve and butyl carbitol; aromatic hydrocarbons, such as toluene and xylene; and amide-based solvents, such as dimethylformamide, dimethylacetamide (DMAc), and N-methylpyrrolidone. The organic solvent may be used alone or two or more kinds thereof may be used in combination.

The drying may be performed by a well-known method, such as heating or hot-air spraying. Conditions for the drying are not particularly limited, but, the drying is performed so that the content of the organic solvent in the resin composition layer is 10% by mass or lower, and preferably 5% by mass or lower. Although depending on the boiling point of the organic solvent in the resin varnish, for example, when use is made of resin varnish containing 30% by mass to 60% by mass of the organic solvent, the resin composition layer can be formed by drying the resin varnish at 50°C to 150°C for 3 minutes to 10 minutes.

In the magnetic sheet, on a surface of the resin composition layer, the surface being not joined to the support, (that is, a surface on a side opposite to the support), a protective film corresponding to the support can be further laminated. The thickness of the protective film is not particularly limited, but is 1 um to 40 um, for example. The lamination of the protective film can prevent the attachment of dusts and the like or the generation of scratch on the surface of the resin composition layer. The magnetic sheet can be wound in a roll form and stored. When the magnetic sheet has the protective film, the magnetic sheet becomes available only after the protective film is peeled off.

### Circuit board and manufacturing method of same

A circuit board of a first embodiment includes: a substrate having a through hole; and a cured product of the magnetic paste of the present invention that is filled in the through hole. A circuit board of a second embodiment includes a magnetic layer formed of a cured product of a resin composition layer of a magnetic sheet. Hereinafter, the first embodiment and the second embodiment of the respective methods of manufacturing the circuit boards will be described. Note that the method of manufacturing a circuit board according to the present invention is not limited to the first and second embodiments exemplified below.

### First embodiment

The circuit board of the first embodiment is manufactured, for example, by a manufacturing method including the following processes (1) and (2). This manufacturing method preferably further includes the following processes (3) and (4). In the first embodiment, a magnetic layer is preferably formed using the magnetic paste.
(1): filling a through hole of a substrate having the through hole with the magnetic paste
(2): thermally curing the magnetic paste to obtain a cured product
(3): polishing a surface of the cured product or the magnetic paste
(4): forming a conductive layer on the polished surface of the cured product

The method of manufacturing the circuit board of the present invention may be performed in the order of the processes (1) to (4), or in such a manner that the process (2) may be performed after the process (3).

Hereinafter, the above-described processes (1) to (4) for manufacturing the circuit board will be described in detail.

### Process (1)

The process (1) may include the process of preparing the magnetic paste. The magnetic paste is as described above.

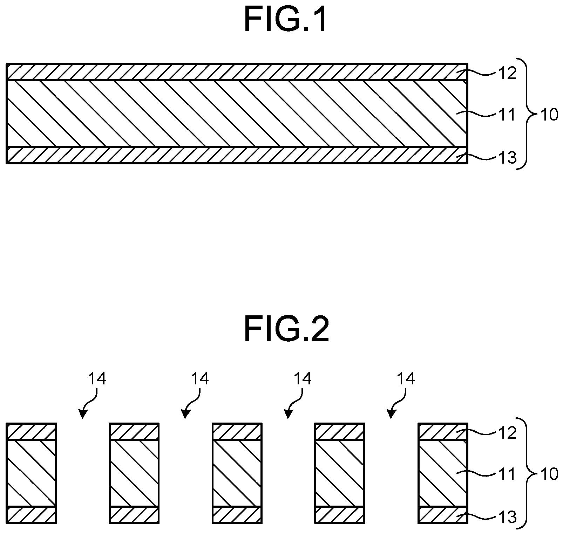

The process (1) may include the process of preparing a core substrate 10 including a support substrate 11, a first metal layer 12, and a second metal layer 13, the first metal layer 12 and the second metal layer 13 being provided in both surfaces of the support substrate 11 respectively and formed of, for example, copper foil, as illustrated in an example of FIG. 1. Examples of a material of the support substrate 11 include a glass epoxy substrate, a metal substrate, a polyester substrate, a polyimide substrate, a bismaleimide triazine (BT) resin substrate, and a thermosetting polyphenylene ether substrate. Examples of a material of the first and the second metal layers include a copper foil with carrier and a material of a later-mentioned conductive layer.

As illustrated in an example in FIG. 2, the process (1) may include the process of forming a through hole 14 in the core substrate 10. The through hole 14 can be formed by, for example, drilling, laser irradiation, or plasma irradiation. Specifically, the through hole 14 can be formed in such a manner that a through hole is formed in the core substrate 10 by drilling, for example.

The formation of the through hole 14 can be performed using a commercially available drilling apparatus. Examples of the commercially available drilling apparatus include ND-1S211, manufactured by Hitachi Via Mechanics, Ltd.

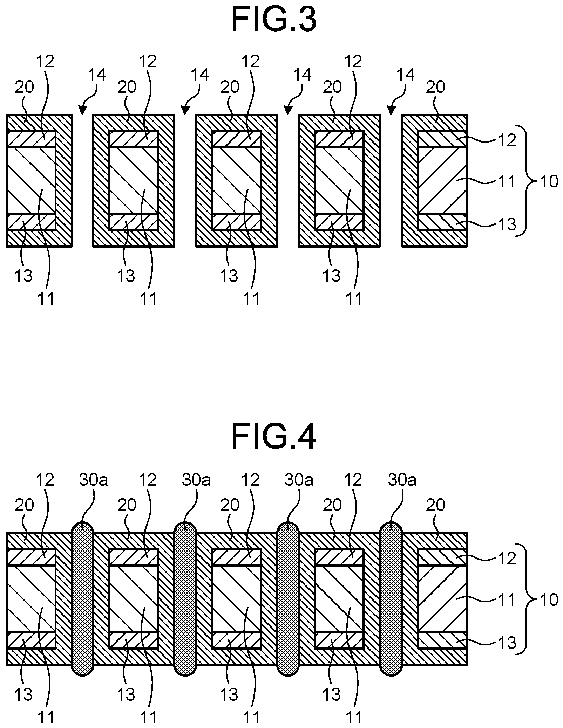

After the formation of the through hole 14 in the core substrate 10, the process (1) may include the process of roughening the core substrate 10 and forming a plating layer 20 inside the through hole 14, on a surface of the first metal layer 12, and on a surface of the second metal layer 13, as illustrated in an example in FIG. 3.

As the above-described roughening, any of dry roughening and wet roughening may be performed. Examples of the dry roughening include plasma processing. Examples of the wet roughening include a method in which swelling treatment with a swelling solution, roughening treatment with an oxidant, and neutralization treatment with a neutralization solution are performed in this order.

The plating layer 20 is formed by plating. A procedure for forming the plating layer 20 by the plating is the same as that for forming a conductive layer at the process (4) described later.

After preparing the core substrate 10 having the plating layer 20 formed inside the through hole 14, the through hole 14 is filled with a magnetic paste 30a, as illustrated in an example in FIG. 4. Examples of a filling method include a method of filling the through hole 14 with the magnetic paste 30a via a squeegee, a method of filling with the magnetic paste 30a via a cartridge, a method of filling with the magnetic paste 30a by mask printing, a roll coating method, and an inkjet method.

### Process (2)

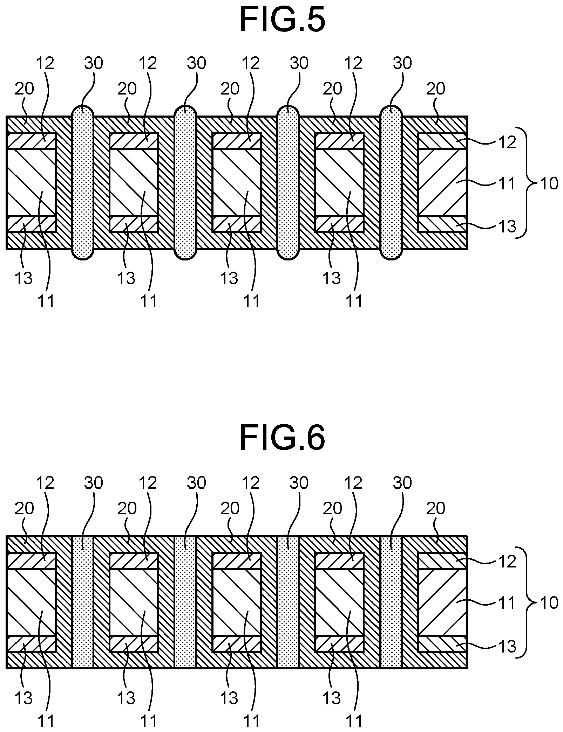

At the process (2), after the through hole 14 is filled with the magnetic paste 30a, the magnetic paste 30a is thermally cured to form a cured product layer (magnetic layer) 30 in the through hole 14, as illustrated in an example in FIG. 5. Conditions for thermal curing the magnetic paste 30a are different in accordance with a composition and a kind of the magnetic paste 30a, but the curing temperature is preferably 120°C or higher, more preferably 130°C or higher, and still more preferably 150°C or higher, and preferably 240°C or lower, more preferably 220°C or lower, and still more preferably 200°C or lower. Time to cure the magnetic paste 30a is preferably 5 minutes or longer, more preferably 10 minutes or longer, and still more preferably 15 minutes or longer, and preferably 120 minutes or shorter, more preferably 100 minutes or shorter, and still more preferably 90 minutes or shorter.

The degree of cure of the magnetic layer 30 at the process (2) is preferably 80% or higher, more preferably 85% or higher, and still more preferably 90% or higher. The degree of cure can be measured, for example, using a differential scanning calorimeter.

Prior to the thermal curing of the magnetic paste 30a, the magnetic paste 30a may be subjected to preheating treatment to be heated at a temperature lower than the curing temperature. For example, prior to the thermal curing of the magnetic paste 30a, the magnetic paste 30a may be preheated, normally at a temperature of 50°C or higher and less than 120°C (preferably 60°C or higher and 110°C or lower, and more preferably 70°C or higher and 100°C or lower), normally for 5 minutes or longer (preferably for 5 minutes to 150 minutes, and more preferably for 15 minutes to 120 minutes).

### Process (3)

At the process (3), as illustrated in an example in FIG. 6, an excessive magnetic layer 30 protruding from or adhering to the core substrate 10 is removed by polishing to planarize the surface. As a method for the polishing, use can be made of a method capable of polishing the excessive magnetic layer 30 protruding from or adhering to the core substrate 10. Examples of the method for the polishing include buffing and belt polishing. Examples of a commercially available buffing apparatus include NT-700IM, manufactured by ISHIIHYOKI CO., LTD.

From the viewpoint of enhancing plating adhesion, the arithmetic average roughness (Ra) of the polished surface of the magnetic layer is preferably 300 nm or more, more preferably 350 nm or more, and still more preferably 400 nm or more. The upper limit is preferably 1000 nm or less, more preferably 900 nm or less, and still more preferably 800 nm or less. The surface roughness (Ra) can be measured, for example, using a non-contact type surface roughness meter.

In the case where the process (3) is performed after the process (2), for the purpose of, for example, further enhancing the degree of cure of the magnetic layer, heat treatment may be performed, if needed, after the process (2) and before the process (3). It is sufficient that the temperature for the heat treatment is in accordance with the above-described curing temperature, and is preferably 120°C or higher, more preferably 130°C or higher, and still more preferably 150°C or higher, and preferably 240°C or lower, more preferably 220°C or lower, and still more preferably 200°C or lower. Time for the heat treatment is preferably 5 minutes or longer, more preferably 10 minutes or longer, and still more preferably 15 minutes or longer, and preferably 90 minutes or shorter, more preferably 70 minutes or shorter, and still more preferably 60 minutes or shorter.

In the case where the process (3) is performed before the process (2), preheating treatment in which heating is performed at a temperature lower than the curing temperature of the magnetic paste may be performed before the process (3). The temperature for the preheating treatment is preferably 100°C or higher, more preferably 110°C or higher, and still more preferably 120°C or higher, and preferably 240°C or lower, more preferably 220°C or lower, and still more preferably 200°C or lower. Time for the heat treatment is preferably 5 minutes or longer, more preferably 10 minutes or longer, and still more preferably 15 minutes or longer, and preferably 90 minutes or shorter, more preferably 70 minutes or shorter, and still more preferably 60 minutes or shorter.

### Process (4)

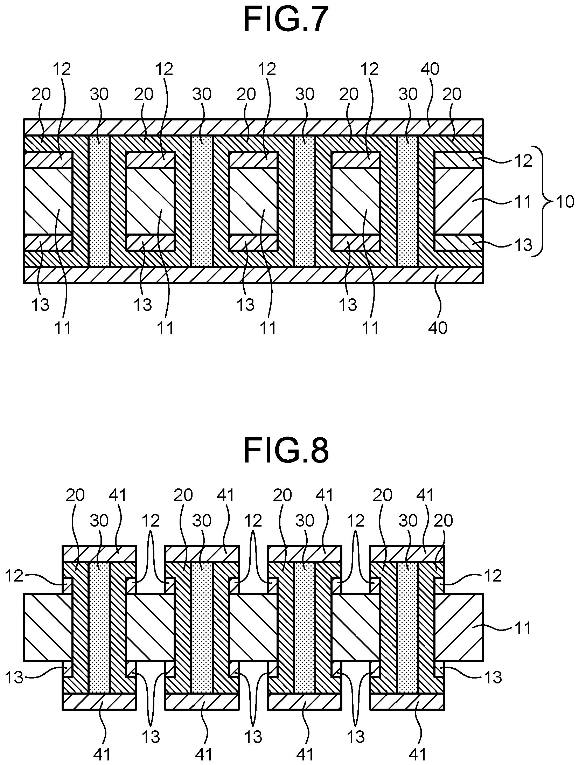

At the process (4), a conductive layer 40 is formed on the polished surface of the magnetic layer 30 and the plating layer 20, as illustrated in an example in FIG. 7. Furthermore, after the formation of the conductive layer 40, the conductive layer 40, the first metal layer 12, the second metal layer 13, and the plating layer 20 may be partially removed by a treatment such as etching to form a pattern conductive layer 41, as illustrated in an example in FIG. 8. The present invention does not include the process of roughening the magnetic layer because the cured product was polished at the process (3). In FIG. 7, the conductive layer 40 is formed on both surfaces of the core substrate 10, but, the conductive layer 40 may be formed on only one surface of the core substrate 10.

Examples of a method for forming the conductive layer include plating, sputtering, and vapor deposition. Among these methods, plating is preferably used. In a preferable embodiment, a surface of the cured product is subjected to plating with an appropriate method, such as a semi-additive method or a full-additive method, to form a pattern conductive layer having a desired wiring pattern. Examples of a material of the conductive layer include single metals, such as gold, platinum, palladium, silver, copper, aluminum, cobalt, chromium, zinc, nickel, titanium, tungsten, iron, tin, and indium; and alloys of two or more kinds of metals selected from the group consisting of gold, platinum, palladium, silver, copper, aluminum, cobalt, chromium, zinc, nickel, titanium, tungsten, iron, tin, and indium. Among these metals, from the viewpoints of for example, versatility, cost, and ease of patterning, chromium, nickel, titanium, aluminum, zinc, gold, palladium, silver, copper, a nickel-chrome alloy, a copper-nickel alloy, or a copper-titanium alloy is preferably used. Chromium, nickel, titanium, aluminum, zinc, gold, palladium, silver, copper, or a nickel-chrome alloy is more preferably used. Copper is still more preferably used.

Here, an embodiment example in which the pattern conductive layer is formed on the polished surface of the cured product will be described in detail. A plating seed layer is formed on the polished surface of the cured product by electroless plating. Subsequently, an electrolytic plating layer is formed on the formed plating seed layer by electrolytic plating, and an unnecessary plating seed layer is removed by, for example, etching, if needed, so that a conductive layer having a desired circuit pattern can be formed. After the formation of the conductive layer, annealing treatment may be performed, if needed, for the purpose of, for example, enhancing the peel strength of the conductive layer. The annealing treatment can be performed by, for example, heating a circuit board at 150°C to 200°C for 20 minutes to 90 minutes.

From the viewpoint of slimming down, the thickness of the pattern conductive layer is preferably 70 um or less, more preferably 60 um or less, still more preferably 50 um or less, still more preferably 40 um or less, and particularly preferably 30 um or less, 20 um or less, 15 um or less, or 10 um or less. The lower limit of the thickness is preferably 1 um or more, more preferably 3 um or more, and still more preferably 5 um or more.

Second embodiment, which is not part of the invention

The circuit board of the second embodiment includes a magnetic layer formed of a cured product of the magnetic paste. In the second embodiment the magnetic layer is preferably formed using a magnetic sheet. Hereinafter, the second embodiment of the method of manufacturing a substrate product will be described. The same description as that for the first embodiment will be appropriately omitted.

The circuit board of the second embodiment is manufactured, for example, by a manufacturing method including the following process (A). This manufacturing method preferably further includes the following processes (B) to (D).
(A) : laminating a magnetic sheet on an inner layer substrate so that a resin composition layer joins to the inner layer substrate to form a magnetic layer
(B) : perforating the magnetic layer
(C) : polishing a surface of the magnetic layer
(D) : forming a conductive layer on the polished surface of the magnetic layer

Hereinafter, the processes (A) to (D) for manufacturing the circuit board will be described in detail.

### Process (A)

The process (A) is the process of laminating a magnetic sheet on an inner layer substrate so that a resin composition layer joins to the inner layer substrate to form a magnetic layer. One embodiment of the process (A) is such that a magnetic sheet is laminated on an inner layer substrate so that a resin composition layer joins to the inner layer substrate, and the resin composition layer is thermally cured to form a magnetic layer.

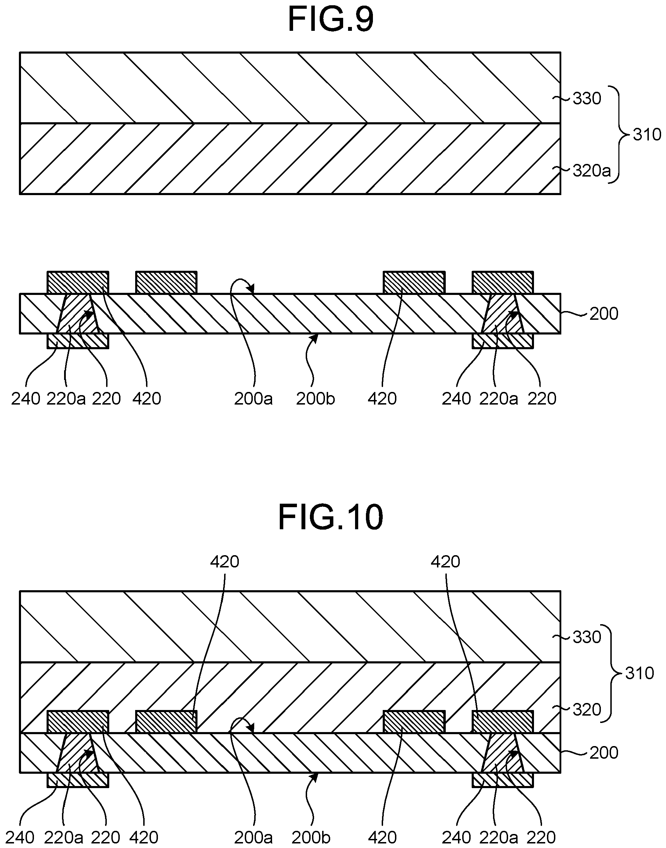

At the process (A), as illustrated in one example in FIG. 9, a magnetic sheet 310 including a support 330 and a resin composition layer 320a provided on the support 330 is laminated on an inner layer substrate 200 so that the resin composition layer 320a joins to the inner layer substrate 200.

The inner layer substrate 200 is an insulating substrate. Examples of a material of the inner layer substrate 200 include insulating base materials, such as a glass epoxy substrate, a metal substrate, a polyester substrate, a polyimide substrate, a bismaleimide triazine (BT) resin substrate, and a thermosetting polyphenylene ether substrate. The inner layer substrate 200 may be an inner layer circuit board in which, for example, wiring are laid within a thickness range thereof.

As illustrated in one example in FIG. 9, the inner layer substrate 200 includes: a first conductive layer 420 provided on a first main surface 200a; and an external terminal 240 provided on a second main surface 200b. The first conductive layer 420 may include a plurality of wirings. In the example in the figure, only wiring that constitutes a coil-shaped conductive structure 400 of an inductor element is illustrated. The external terminal 240 is a terminal to be electrically connected to a not-illustrated external device or the like. The external terminal 240 can constitute a part of conductive layer provided on the second main surface 200b.

A conductive material which can constitute the first conductive layer 420 and the external terminal 240 is the same as the material of the conductive layer described at the process (4) of the first embodiment.

The first conductive layer 420 and the external terminal 240 may have a single layer structure, or alternatively have a multilayered structure in which two or more of single metal layers or alloy layers that are formed of different metals or alloys thereof are laminated. The thicknesses of the first conductive layer 420 and the external terminal 240 are the same as that of the second conductive layer 440 described later.

The ratio of line (L) / space (S) of the first conductive layer 420 and the external terminal 240 is not particularly limited, but, from the viewpoints of achieving a magnetic layer having reduced projections-and-recesses in a surface thereof and thereby being excellent in surface smoothness, the ratio of line (L) / space (S) is usually 900/900 um or less, preferably 700/700 µm or less, more preferably 500/500 um or less, still more preferably 300/300 um or less, and still more preferably 200/200 um or less. The lower limit of the line/space ratio is not particularly limited, but, from the viewpoint of making better the embedding of the resin composition layer into a space, the lower limit is preferably 1/1 um or more.

The inner layer substrate 200 may have a plurality of through holes 220 penetrating the inner layer substrate 200 from the second main surface 200b to the first main surface 200a. Through-hole wiring 220a is provided in each of the through holes 220. The through-hole wiring 220a is configured to electrically connect the first conductive layer 420 to the external terminal 240.

The resin composition layer 320a and the inner layer substrate 200 can be joined by, for example, thermocompression-bonding the magnetic sheet 310 to the inner layer substrate 200 from a support 330 side. Examples of a member (hereinafter, also referred to as a thermocompression-bonding member) for thermocompression-bonding the magnetic sheet 310 to the inner layer substrate 200 include a heated metal plate (for example, a stainless steel (SUS) panel) and a metal roll (a SUS roll). Note that, it is not preferable that the thermocompression-bonding member is brought into direct contact with the magnetic sheet 310 and pressed thereon, but, the thermocompression-bonding member is preferably pressed on the magnetic sheet 310 via a sheet made of an elastic material such as heat-resistant rubber so that the magnetic sheet 310 satisfactorily extends along projections and recesses of a surface of the inner layer substrate 200.

The temperature for the thermocompresssion-bonding is in a range of preferably 80°C to 160°C, more preferably 90°C to 140°C, and still more preferably 100°C to 120°C. The pressure for the thermocompresssion-bonding is in a range of preferably 0.098 MPa to 1.77 MPa and more preferably 0.29 MPa to 1.47 MPa. The time period for the thermocompresssion-bonding is in a range of preferably 20 seconds to 400 seconds and more preferably 30 seconds to 300 seconds. The joining of the magnetic sheet to the inner layer substrate is preferably performed at a reduced pressure of 26.7 hPa or lower.

The joining of the resin composition layer 320a of the magnetic sheet 310 and the inner layer substrate 200 can be performed using a commercially available vacuum laminator. Examples of the commercially available vacuum laminator include a vacuum air-pressed laminator manufactured by Meiki Co., Ltd. and a vacuum applicator manufactured by Nikko-Materials Co., Ltd.

After the joining of the magnetic sheet 310 and the inner layer substrate 200, the smoothing of the laminated magnetic sheets 310 may be performed, for example, by pressing the thermocompression-bonding member from the support side under normal pressure (under atmospheric pressure). Pressing conditions for the smoothing can be the same as the thermocompression-bonding conditions for the lamination. The smoothing may be performed using a commercially available laminator. Note that the lamination and the smoothing may be successively performed using the above-mentioned commercially available vacuum laminator.

After laminating the magnetic sheet on the inner layer substrate, the resin composition layer is thermal cured to form a magnetic layer. As illustrated in one example in FIG. 10, the resin composition layer 320a joining to the inner layer substrate 200 is thermal cured to form a first magnetic layer 320.

Although conditions for thermally curing the resin composition layer 320a depend on the composition and kind of the resin composition, curing temperature is preferably 120°C or higher, more preferably 130°C or higher, and still more preferably 150°C or higher, and preferably 240°C or lower, more preferably 220°C or lower, and still more preferably 200°C or lower. Curing time for the resin composition layer 320a is preferably 5 minutes or longer, more preferably 10 minutes or longer, and still more preferably 15 minutes or longer, and preferably 120 minutes or shorter, more preferably 100 minutes or shorter, and still more preferably 90 minutes or shorter.

The support 330 may be removed after the thermally curing of the process (A) and before the process (B), or alternatively may be peeled off after the process (B) .

### Process (B)

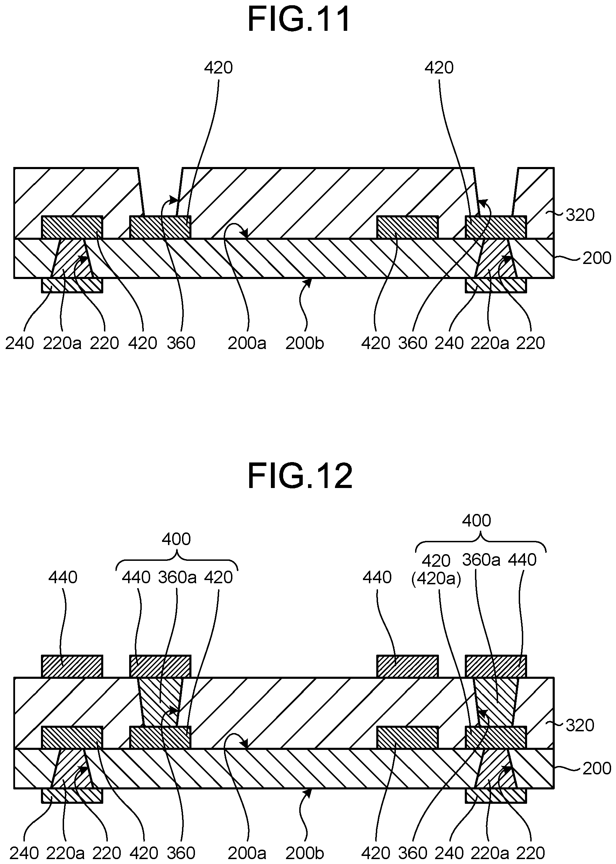

At the process (B), as illustrated in one example in FIG. 11, the first magnetic layer 320 is perforated to form a via hole 360. The via hole 360 functions as a path for electrically connecting the first conductive layer 420 to a later-mentioned second conductive layer 440. In accordance with, for example, the composition of the resin composition used for the formation of the magnetic layer, the via hole 360 may be formed using a drill, laser, plasma, or the like. The size and shape of the hole may be suitably determined in accordance with the design of a printed wiring board.

### Process (C)

At the process (C), a surface of the magnetic layer having the via hole formed therein is polished. A method for the polishing at the process (C) can be the same as that described at the process (3) of the first embodiment.

From the viewpoint of enhancing plating adhesion, the arithmetic average roughness (Ra) of the polished surface of the magnetic layer is preferably 300 nm or more, more preferably 350 nm or more, and still more preferably 400 nm or more. The upper limit of the arithmetic average roughness (Ra) is preferably 1000 nm or less, more preferably 900 nm or less, and still more preferably 800 nm or less. The surface roughness (Ra) can be measured using a non-contact type surface roughness meter, for example.

### Process (D)

At the process (D), as illustrated in one example in FIG. 12, the second conductive layer 440 is formed on the first magnetic layer 320.

A conductive material that can constitute the second conductive layer 440 is the same as the material of the conductive layer described at the process (4) of the first embodiment.

From the viewpoint of slimming down, the thickness of the second conductive layer 440 is preferably 70 um or less, more preferably 60 um or less, still more preferably 50 um or less, still more preferably 40 um or less, and particularly preferably 30 um or less, 20 um or less, 15 um or less, or 10 um or less. The lower limit of the thickness is preferably 1 um or more, more preferably 3 um or more, and still more preferably 5 um or more.

The second conductive layer 440 can be formed by metal plating. The second conductive layer 440 is preferably formed by a wet plating method, such as a semi-additive method and a full-additive method, including, for example, an electroless plating process, a mask pattern formation process, an electrolytic plating process, and a flash etching process. When the second conductive layer 440 is formed using the wet plating method, the formed second conductive layer 440 can have a desired wiring pattern. Note that, through this process, via-hole wiring 360a is also formed inside the via hole 360.

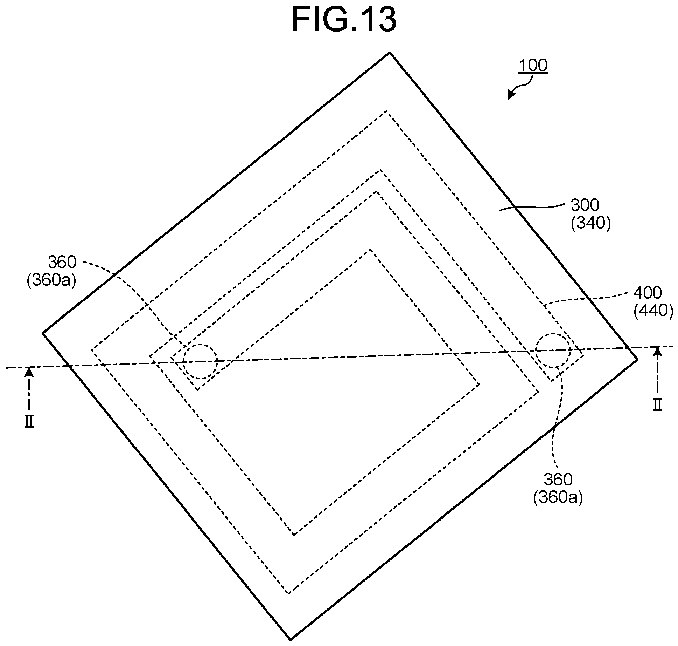

As illustrated in examples in FIG. 13 to FIG. 15, the first conductive layer 420 and the second conductive layer 440 may be spirally provided. In an example, one end, closer to the center, of a spiral wiring part of the second conductive layer 440 is electrically connected to one end, closer to the center, of a spiral wiring part of the first conductive layer 420 via the via-hole wiring 360a. Another end, closer to the outer periphery, of the spiral wiring part of the second conductive layer 440 is electrically connected to a land 420a of the first conductive layer 420 via the via-hole wiring 360a. Thus, the other end, closer to the outer periphery, of the spiral wiring part of the second conductive layer 440 is electrically connected to the external terminal 240 via the via-hole wiring 360a, the land 420a, and the through-hole wiring 220a.

The coil-shaped conductive structure 400 includes: the spiral wiring part that is a part of the first conductive layer 420; the spiral wiring part that is a part of the second conductive layer 440; and the via-hole wiring 360a configured to electrically connect the spiral wiring part of the first conductive layer 420 to the spiral wiring part of the second conductive layer 440.

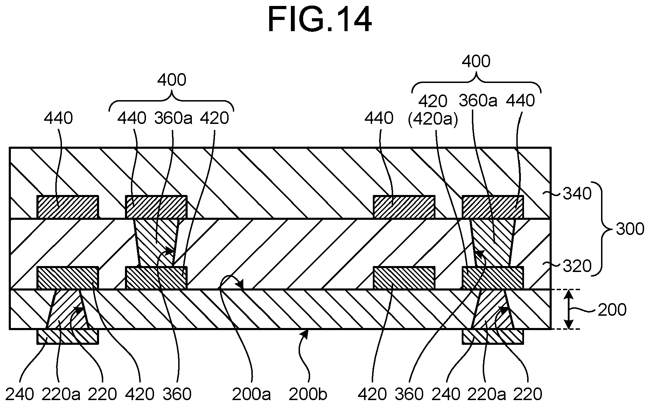

After the process (D), the process of further forming a magnetic layer on the conductive layer may be performed. Specifically, as illustrated in an example in FIG. 14, a second magnetic layer 340 is formed on the first magnetic layer 320 having the second conductive layer 440 and the via-hole wiring 360a formed therein. The second magnetic layer may be formed by the same processes as those already described.

### Inductor component

An inductor component includes the circuit board of the present invention. When including the circuit board obtained by the method of manufacturing the circuit board of the first embodiment, such inductor component has an inductor pattern formed of a conductor in at least a part of the circumference of the cured product of the magnetic paste. As the inductor component, for example, an inductor component described in Japanese Patent Application Laid-open No. 2016-197624 can be applied.

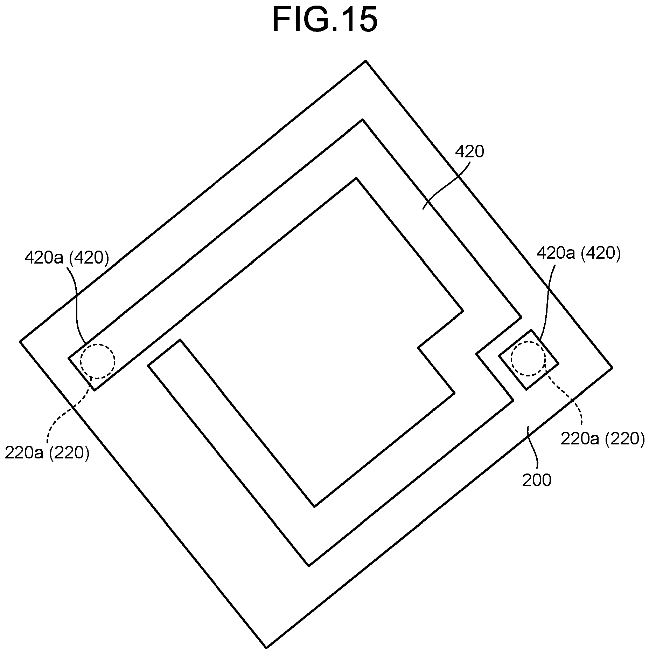

When including the circuit board obtained by the method of manufacturing the circuit board of the second embodiment, an inductor substrate includes: a magnetic layer; and a conductive structure at least a part of which is embedded in the magnetic layer, and the inductor substrate includes an inductor element including the conductive structure and a part of the magnetic layer extending in the thickness direction of the magnetic layer and surrounded by the conductive structure. Here, FIG. 13 is a schematic plan view of the inductor substrate including the inductor element built therein, when seen from one side in the thickness direction of the inductor substrate. FIG. 14 is a schematic diagram of an end cross-section of the inductor substrate, when taken along a dot- and-dash line II-II in FIG. 13. FIG. 15 is a schematic plan view to describe a configuration of the first conductive layer of the inductor substrate.

As illustrated in an example in FIG. 13 and FIG. 14, a circuit board 100 is a build-up wiring board including a plurality of magnetic layers (the first magnetic layer 320 and the second magnetic layer 340) and a plurality of conductive layers (the first conductive layer 420 and the second conductive layer 440), in other words, including a build-up magnetic layer and a build-up conductive layer. The inductor substrate 100 further includes the inner layer substrate 200.

As illustrated in FIG. 14, the first magnetic layer 320 and the second magnetic layer 340 constitute a magnetic part 300 that can be regarded as an integrated magnetic layer. Accordingly, the coil-shaped conductive structure 400 is provided so that at least a part of the coil-shaped conductive structure 400 is embedded in the magnetic part 300. In other words, in the inductor substrate 100 of the present embodiment, the inductor element includes: the coil-shaped conductive structure 400; and a core part that is a part of the magnetic part 300 extending in the thickness direction of the magnetic part 300 and surrounded by the coil-shaped conductive structure 400.

As illustrated in an example in FIG. 15, the first conductive layer 420 includes: a spiral wiring part configured to constitute the coil-shaped conductive structure 400; and the rectangular land 420a electrically connected to the through-hole wiring 220a. In the illustrated example, the spiral wiring part includes a linear part, a bent part bent at a right angle, and a detour part detouring around the land 420a. In the illustrated example, the spiral wiring part of the first conductive layer 420 has an approximately rectangular shape as the whole outline and is wound counterclockwise from the center toward the outside.

Similarly, the second conductive layer 440 is formed on the first magnetic layer 320. The second conductive layer 440 includes a spiral wiring part configured to constitute the coil-shaped conductive structure 400. In FIG. 13 or FIG. 14, the spiral wiring part includes a linear part and a bent part bent at a right angle. In FIG. 13 or FIG. 14, the spiral wiring part of the second conductive layer 440 has an approximately rectangular shape as the whole outline and is wound clockwise from the center toward the outside.

Such an inductor component can be used as a wiring board on which an electronic component, such as a semiconductor chip, is to be mounted, or the inductor component can be used as a (multilayer) printed wiring board that uses the wiring board as an inner layer substrate. Alternatively, the inductor component can be used as a chip inductor component obtained by making the wiring board into individual pieces, or can be used as a printed wiring board onto which the chip inductor component is surface-mounted.

Using the wiring board, various types of semiconductor devices can be produced. A semiconductor device including the wiring board can be preferably used for electrical products (for example, a computer, a cellular phone, a digital camera, and a television) and vehicles (for example, a motorcycle, an automobile, a train, a ship, and an airplane).

### Examples

Hereinafter, the present invention will be more specifically described using examples, but the present invention is not limited to these examples. Note that, in the following description, "part(s)" and "%" representing an amount mean "part(s) by mass" and "% by mass", respectively, unless otherwise specified.

### Dispersant pH measurement (indicator method)

A dispersant was dissolved in acetone to produce a measurement sample (22°C) having a dispersant concentration of 0.1 g/mL. A pH test paper was dipped gently in the measurement sample, and pulled up to dry excessive moisture. The color of a wet portion of the test paper was compared with a color sample, and a pH represented by the closest color in the color sample to the color of the wet portion was regarded as the pH of the sample.

### Synthesis Example 1: Synthesis of dispersant 1

Into a reaction flask equipped with a thermometer, a stirrer, a nitrogen inlet, and a reflux tube, 10.0 parts of 12-hydroxystearic acid (manufactured by JUNSEI CHEMICAL CO., LTD.) and 190 parts of ε-caprolactone (manufactured by JUNSEI CHEMICAL CO., LTD.) were charged, and heated to 160°C over 4 hours in a nitrogen gas stream, and further heated at 160°C for 2 hours, and then heated until the remaining amount of the ε-caprolactone became 1% or less. Subsequently, the mixture was cooled to room temperature. Hereinafter, this resultant reaction solution is referred to as a dispersant 1. The dispersant 1 had a polyester skeleton in which R in the formula (1) was an alkylene group having 5 carbon atoms, and had a weight-average molecular weight of 23,000 and an acid value of 9.0 mg KOH/g. When the pH of the dispersant 1 was measured by the indicator method, pH = 5.

### Synthesis Example 2: Synthesis of dispersant 2

Into a reaction flask equipped with a thermometer, a stirrer, a nitrogen inlet, and a reflux tube, 10.0 parts of 12-hydroxystearic acid (manufactured by JUNSEI CHEMICAL CO., LTD.) and 180 parts of δ-valerolactone (manufactured by Tokyo Chemical Industry Co., Ltd.) were charged, and further heated to 160°C over 4 hours in a nitrogen gas stream, and heated at 160°C for 2 hours, and then heated until the remaining amount of the δ-valerolactone became 1% or less. Subsequently, the mixture was cooled to room temperature. Hereinafter, this resultant reaction solution is referred to as a dispersant 2. The dispersant 2 had a polyester skeleton in which R in the formula (1) was an alkylene group having 4 carbon atoms, and had a weight-average molecular weight of 22,000 and an acid value of 8.9 mg KOH/g. When the pH of the dispersant 2 was measured by the indicator method, pH = 5.

### Synthesis Example 3: Synthesis of dispersant 3

Into a reaction flask equipped with a thermometer, a stirrer, a nitrogen inlet, and a reflux tube, a mixture of 25.0 parts of xylene and 70 parts of a 10% polyallylamine solution (PAA-1LV, manufactured by Nitto Boseki Co., Ltd. and having a number average molecular weight of approximately 3,000) were charged and stirred at 160°C, and water was distilled off by using a separator, and also, while xylene was returned to the reaction solution, what was obtained by heating 114.21 parts of the polyester dispersant obtained in Synthesis Example 1 to 160°C was added to the reaction solution, and the resultant mixture was allowed to react at 160°C for 2 hours. Furthermore, the mixture was heated at 160°C for 4 hours, and xylene was distilled off to obtain a dispersant 3. The dispersant 3 had a polyester skeleton in which R in the formula (1) was an alkylene group having 5 carbon atoms, and had an amine value of 31.0 mg KOH/g. and an acid value of 19.5 mg KOH/g. The amine value immediately after the mixing was 312.6 mg KOH/g. When the pH of the dispersant 3 was measured by the indicator method, pH = 6.

### Synthesis Example 4: Synthesis of dispersant 4

Into a reaction flask equipped with a thermometer, a stirrer, a nitrogen inlet, a reflux tube, and a water separator, 30.0 parts of xylene (manufactured by JUNSEI CHEMICAL CO., LTD.), 300.0 parts of 12-hydroxystearic acid (manufactured by JUNSEI CHEMICAL CO., LTD.), and 0.1 parts of tetrabutyl titanate (manufactured by Tokyo Chemical Industry Co., Ltd.) were charged, and heated to 160°C over 4 hours in a nitrogen gas stream. The mixture was further heated at 160°C for 4 hours, and xylene was distilled off at 160°C. A dispersant 4 had a polyester skeleton in which R in the formula (1) was an alkylene group having 11 carbon atoms, and had a weight-average molecular weight of 6,000. The acid value of the dispersant 4 was 23.0 mg KOH/g. When the pH of the dispersant 4 was measured by the indicator method, pH = 5.

### Synthesis Example 5: Synthesis of dispersant 5

Into a reaction flask equipped with a thermometer, a stirrer, a nitrogen inlet, a reflux tube, and a water separator, 30.0 parts of xylene (manufactured by JUNSEI CHEMICAL CO., LTD.), 300.0 parts of 12-hydroxystearic acid (manufactured by JUNSEI CHEMICAL CO., LTD.), and 0.1 parts of tetrabutyl titanate (manufactured by Tokyo Chemical Industry Co., Ltd.) were charged, and heated to 160°C over 4 hours in a nitrogen gas stream. The mixture was further heated at 160°C for 4 hours (at this time point, the acid value was approximately 20 mg KOH/g), and xylene was distilled off at 160°C. Subsequently, the mixture was cooled to room temperature, and water produced during the heating reaction was separated from xylene present in a distillate, and the separated xylene was returned to the reaction solution. This reaction solution is referred to as a polyester PE-1.

Into a reaction flask equipped with a thermometer, a stirrer, a nitrogen inlet, a reflux tube, and a water separator, a mixture of 25.0 parts of xylene and 70 parts of a 10% polyallylamine solution (PAA-1LV, manufactured by Nitto Boseki Co., Ltd. and having a number average molecular weight of approximately 3,000) were charged and stirred at 160°C, and water was distilled off by using the separator, and also, while xylene was returned to the reaction solution, 2.5 parts of the polyester PE-1 was added to the reaction solution, and the resultant mixture was allowed to react at 160°C for 2 hours. The mixture was further heated at 160°C for 4 hours, and xylene was distilled off at 160°C. A dispersant 5 had a polyester skeleton in which R in the formula (1) was an alkylene group having 11 carbon atoms, and had an amine value of 38.5 mg KOH/g and an acid value of 23.5 mg KOH/g. The amine value of the dispersant 5 immediately after the mixing was 317 mg KOH/g. When the pH of the dispersant 5 was measured by the indicator method, pH = 6.

### Example 1: Preparation of magnetic paste 1

3 parts by mass of an epoxy resin (ZX-1059, a mixed product of a bisphenol A epoxy resin and a bisphenol F epoxy resin, manufactured by NIPPON STEEL Chemical & Material Co., Ltd.), 5 parts by mass of an epoxy resin (ZX-1658GS, cyclic aliphatic diglycidyl ether, manufactured by NIPPON STEEL Chemical & Material Co., Ltd.), 10 parts by mass of an epoxy resin (EX-201, a cyclic aliphatic diglycidyl ether epoxy resin, manufactured by Nagase ChemteX Corporation), 1 part by mass of the dispersant 1, 1 part by mass of a curing agent (2MZA-PW, an imidazole-based epoxy resin curing agent, manufactured by SHIKOKU CHEMICALS CORPORATION), 120 parts by mass of magnetic powder (M05S, Fe-Mn-based ferrite, having an average particle diameter of 3 um, manufactured by Powdertech Co., Ltd.), and 30 parts by mass of magnetic powder (M001, Fe-Mn-based ferrite, having an average particle diameter of 0.2 um, manufactured by Powdertech Co., Ltd.) were mixed to prepare a magnetic paste 1.

### Example 2: Preparation of magnetic paste 2

A magnetic paste 2 was prepared in the same manner as in Example 1, except that 1 part by mass of the dispersant 1 in Example 1 was changed to 1 part by mass of the dispersant 2.

### Example 3: Preparation of magnetic paste 3

A magnetic paste 3 was prepared in the same manner as in Example 1, except that 1 part by mass of the dispersant 1 in Example 1 was changed to 1 part by mass of the dispersant 3.

### Comparative Example 1: Preparation of magnetic paste 4

A magnetic paste 4 was prepared in the same manner as in Example 1, except that 1 part by mass of the dispersant 1 in Example 1 was changed to 1 part by mass of the dispersant 4.

### Comparative Example 2: Preparation of magnetic paste 5

A magnetic paste 5 was prepared in the same manner as in Example 1, except that 1 part by mass of the dispersant 1 in Example 1 was changed to 1 part by mass of the dispersant 5.

### Comparative Example 3: Preparation of magnetic paste 6

A magnetic paste 6 was prepared in the same manner as in Example 1, except that, in Example 1, the amount of the magnetic powder (M05S, Fe-Mn-based ferrite, having an average particle diameter of 3 um, manufactured by Powdertech Co., Ltd.) was changed from 120 parts by mass to 50 parts by mass, the amount of the magnetic powder (M001, Fe-Mn-based ferrite, having an average particle diameter of 0.2 um, manufactured by Powdertech Co., Ltd.) was changed from 30 parts by mass to 11 parts by mass, and 1 part by mass of the dispersant 1 was changed to 0.5 parts by mass of the dispersant 4.

### Comparative Example 4: Preparation of magnetic paste 7

A magnetic paste 7 was prepared in the same manner as in Example 1, except that 1 part by mass of the dispersant 1 in Example 1 was changed to 1 part by mass of a dispersant (SC-1015F, a dispersant not having a polyester skeleton, manufactured by NOF CORPORATION, pH = 3 when measured by the indicator method).

### Measurement of viscosity of magnetic paste

The temperature of each of the magnetic pastes 1 to 7 was kept at 25±2°C, and the viscosity thereof at 25°C was measured using an E-type viscometer (RE-80U, manufactured by TOKI SANGYO CO., LTD., 3° × R9.7 cone, 5 rpm). From the viewpoint of handleability, the measured viscosity was evaluated on the following criteria.
∘: less than 300 Pa·s
×: 300 Pa·s or more

### Evaluation of printability

### (1) Preparation of support substrate

A support substrate having a plurality of through holes uniformly formed therein (a 700-um-thick substrate obtained by impregnating glass fabric with epoxy resin and curing the epoxy resin) was prepared. Each of the through holes was a cylindrical hole and had a diameter of 350 um. The space between the through holes was 100 um.

### (2) Preparation of mask

As a mask, there was prepared a metal mask in which an opening as a hollow hole was formed in a 100-pm-thick metal plate. The plane shape of the opening was a 20-mm square.

### (3) Magnetic paste printing

Using the above-mentioned mask, each of the magnetic pastes was printed on the support substrate in accordance with the following (3-1) to (3-3) processes. Note that the printing was performed using a vacuum high-precision screen printer (LS-100VC, manufactured by Newlong Seimitsu Kogyo Co., Ltd).

### (3-1) Placement process

The mask was placed on one side of the support substrate. Here, the mask was placed so that one opening of the mask communicated with the through holes of the support substrate.

### (3-2) Supplying process

Subsequently, the magnetic paste was supplied to one face of the mask, the face being opposite to the other face closer to the support substrate.

### (3-3) First printing process

Subsequently, the magnetic paste was printed by moving a rubber squeegee, that is, a squeegee formed with rubber as an elastic material (SVFSQ, manufactured by Newlong Seimitsu Kogyo Co., Ltd. and having a thickness of 9 mm and a rubber hardness of 90), on the face of the mask along the face. The printing was performed with a squeegee attack angle of 10°, a printing pressure of 4.4 MPa, and a print speed of 5 mm/sec.

### (4) Curing of magnetic paste

By the above-described printing, a filled substrate including the support substrate and the resin composition layer was obtained. This filled substrate was heated at 130°C for 30 minutes. Through the heating, the resin composition layer was thermally cured to form a filling layer, whereby a hole-filled substrate was obtained.

### (5) Evaluation of printability

The condition of the obtained hole-filled substrate was measured using a laser microscope. From the result of measurement, the printability of each of the magnetic pastes was evaluated, based on the following criteria.
o: no through hole recessed from the support substrate in the back-side face of the hole-filled substrate.
×: one or more through holes recessed from the support substrate in the back-side face of the hole-filled substrate.

Here, the expression "the back-side face of the hole-filled substrate" means one face of the support substrate being opposite to the other face having the mask placed thereon. The expression "a through hole recessed from the support substrate in the back-side face of the hole-filled substrate" means a through hole in which the filling layer filled in the through hole is recessed from the back-side face of the support substrate. In other words, the expression "a through hole recessed from the support substrate in the back-side face of the hole-filled substrate" means a through hole in which one face of the filling layer filled in the through hole, the one face being opposite to the other face closer to the mask, is positioned closer to the mask in the thickness direction than the back-side face of the support substrate.

### Measurement of mechanical strength (tensile break strength)

As a support, a polyethylene terephthalate (PET) film (PET501010, manufactured by LINTEC Corporation, 50 um in thickness) having been subjected to treatment with a silicon-based mold-release agent was prepared. Each of the magnetic pastes 1 to 7 was uniformly applied onto a release surface of the PET film by a doctor blade so as to achieve a paste layer thickness of 100 um after drying, whereby a magnetic sheet was obtained. The obtained magnetic sheet was heated at 180°C for 90 minutes to thermal cure the paste layer, and the support was detached from the magnetic sheet to obtain a cured product in a sheet form. The obtained sample was subjected to tensile break strength measurement in accordance with JIS K7127. The measurement result was evaluated on the following criteria.
o: mechanical strength of 50 MPa or higher
×: mechanical strength of lower than 50 MPa

### Measurement of relative magnetic permeability and magnetic loss

As a support, a polyethylene terephthalate (PET) film (PET501010, manufactured by LINTEC Corporation, 50 um in thickness) having been subjected to treatment with a silicone resin-based mold-release agent was prepared. Each of the magnetic pastes 1 to 7 was uniformly applied onto a release surface of the PET film by a doctor blade so as to achieve a paste layer thickness of 100 µm after drying, whereby a magnetic sheet was obtained. The obtained magnetic sheet was heated at 180°C for 90 minutes to thermal cure the paste layer, and the support was detached from the magnetic sheet to obtain a cured product in a sheet form. The obtained cured product was cut into a test piece having a width of 5 mm and a length of 18 mm to obtain an evaluation sample. The relative magnetic permeability (µ') and the magnetic loss (µ'') of the evaluation sample were measured at a room temperature of 23°C and a measurement frequency of 100 MHz by a three-turn coil method using HP8362B (manufactured by Agilent Technologies, Ltd).

**[Table 1]**

| (Table 1) | | | | | | | | | |
|---|---|---|---|---|---|---|---|---|---|
| | | | Example | | | Comparative Example | | | |
| | | | 1 | 2 | 3 | 1 | 2 | 3 | 4 |
| Component (A) | Component (A-1) | M05S | 120 | 120 | 120 | 120 | 120 | 50 | 120 |
| | Component (A-2) | M001 | 30 | 30 | 30 | 30 | 30 | 11 | 30 |
| Component (B) | ZX-1059 | | 3 | 3 | 3 | 3 | 3 | 3 | 3 |
| | ZX-1658GS | | 5 | 5 | 5 | 5 | 5 | 5 | 5 |
| | EX-201 | | 10 | 10 | 10 | 10 | 10 | 10 | 10 |
| Component (C) | Dispersant 1 | | 1 | | | | | | |
| | Dispersant 2 | | | 1 | | | | | |
| | Dispersant 3 | | | | 1 | | | | |
| Component (D) | 2MZA-PW | | 1 | 1 | 1 | 1 | 1 | 1 | 1 |
| Component (E) | Dispersant 4 | | | | | 1 | | 0.5 | |
| | Dispersant 5 | | | | | | 1 | | |
| | SC-1015F | | | | | | | | 1 |
| Total amount (parts by mass) | | | 170 | 170 | 170 | 170 | 170 | 81 | 170 |
| Viscosity (5 rpm, Pa·s) | | | ○ | ○ | ○ | × | × | ○ | × |
| | | | 180 | 190 | 150 | >300 | >300 | 140 | 250 |
| Printability | | | ○ | ○ | ○ | × | × | ○ | × |
| Mechanical strength (MPa) | | | ○ | ○ | ○ | × | × | × | × |
| | | | 65 | 62 | 68 | 38 | 42 | 45 | 53 |
| Relative permeability (100 MHz) | | | 7.4 | 7.5 | 7.5 | 7.3 | 7.2 | 4.5 | 7.4 |
| Magnetic loss (100 MHz) | | | 0.09 | 0.11 | 0.09 | 0.08 | 0.1 | 0.06 | 0.1 |

## Claims

1. Use of a magnetic paste for through-hole filling in a circuit board, wherein the magnetic paste comprises:
magnetic powder (A);
an epoxy resin (B);
a dispersant (C); and
a curing agent (D), wherein
the dispersant (C) has a polyester skeleton represented by a formula (1) below, 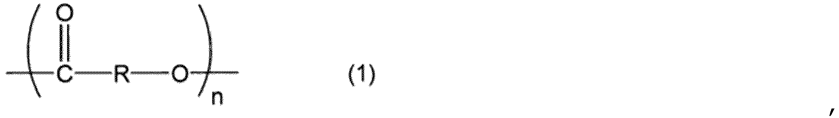 wherein R is independently a divalent hydrocarbon group having 2 to 10 carbon atoms, and n is an integer of 2 to 1,000.

2. The use according to claim 1, wherein a content of the dispersant (C) is 0.1% by mass or higher and 5% by mass or lower with respect to 100% by mass of non-volatile components in the magnetic paste.

3. The use according to claim 1 or 2, wherein the magnetic powder (A) is at least one selected from iron oxide powder and iron alloy-based metal powder.

4. The use according to any one of claims 1 to 3, wherein
the magnetic powder (A) includes iron oxide powder, and
the iron oxide powder includes ferrite containing at least one selected from Ni, Cu, Mn, and Zn.

5. The use according to any one of claims 1 to 4, wherein a content of the magnetic powder (A) is 70% by mass or higher and 98% by mass or lower with respect to 100% by mass of non-volatile components in the magnetic paste.

6. The use according to any one of claims 1 to 5, wherein the dispersant (C) includes a polyallylamine skeleton.

7. The use according to any one of claims 1 to 6, wherein the magnetic paste is cured.

8. A circuit board, comprising:
a substrate having a through hole; and
a cured product of a magnetic paste comprising:
magnetic powder (A);
an epoxy resin (B);
a dispersant (C); and
a curing agent (D), wherein
the dispersant (C) has a polyester skeleton represented by a formula (1) below, 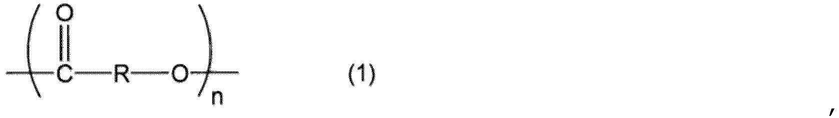 wherein R is independently a divalent hydrocarbon group having 2 to 10 carbon atoms, and n is an integer of 2 to 1,000, the magnetic paste being filled in the through hole.

9. A circuit board according to claim 8, wherein:
(i) a content of the dispersant (C) is 0.1% by mass or higher and 5% by mass or lower with respect to 100% by mass of non-volatile components in the magnetic paste;
and/or
(ii) the magnetic powder (A) is at least one selected from iron oxide powder and iron alloy-based metal powder; and/or
(iii) the magnetic powder (A) includes iron oxide powder, and
the iron oxide powder includes ferrite containing at least one selected from Ni, Cu, Mn, and Zn;
and/or
(iv) a content of the magnetic powder (A) is 70% by mass or higher and 98% by mass or lower with respect to 100% by mass of non-volatile components in the magnetic paste.

10. A circuit board according to claim 8 or 9, wherein the dispersant (C) includes a polyallylamine skeleton.

11. An inductor component, comprising the circuit board according to any one of claims 8, 9 or 10.

12. A method for producing a circuit board, according to any one of claims 8, 9 or 10, or for producing an inductor component according to claim 11, the method comprising producing a magnetic paste comprising stir blending components (A)-(D), wherein the magnetic powder (A) comprises:
magnetic powder (A-1) having an average particle diameter of 1 µm or larger; and
magnetic powder (A-2) having an average particle diameter of smaller than 1 µm.

13. A method for producing the circuit board or the inductor component according to claim 12, the method comprising stir blending components (A)-(D), wherein the magnetic powder (A) comprises:
magnetic powder (A-1) having an average particle diameter of 1 µm or larger and 10 µm or smaller; and
magnetic powder (A-2) having an average particle diameter of 0.005 µm or larger and smaller than 1 µm.

## Patentansprüche

1. Verwendung einer magnetischen Paste zum Füllen eines Durchgangslochs in einer Platine, wobei die magnetische Paste Folgendes umfasst:
magnetisches Pulver (A);
ein Epoxidharz (B);
ein Dispergiermittel (C); und
ein Härtungsmittel (D), wobei
das Dispergiermittel (C) ein Polyestergerüst aufweist, das durch die nachstehende Formel (1) dargestellt ist, 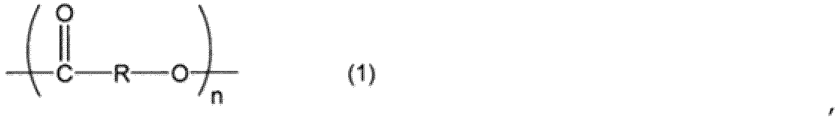 worin R unabhängig eine zweiwertige Kohlenwasserstoffgruppe mit 2 bis 10 Kohlenstoffatomen ist und n eine ganze Zahl von 2 bis 1.000 ist.

2. Verwendung nach Anspruch 1, wobei ein Gehalt des Dispergiermittels (C) 0,1 Massen-% oder mehr und 5 Massen-% oder weniger beträgt, bezogen auf 100 Massen-% von nichtflüchtigen Komponenten in der magnetischen Paste.

3. Verwendung nach Anspruch 1 oder 2, wobei das magnetische Pulver (A) zumindest eines ist, das aus Eisenoxidpulver und einem Metallpulver auf Eisenlegierungsbasis ausgewählt ist.

4. Verwendung nach einem der Ansprüche 1 bis 3, wobei das magnetische Pulver (A) Eisenoxidpulver umfasst und
das Eisenoxidpulver Ferrit umfasst, das zumindest eines ausgewählt aus Ni, Cu, Mn und Zn enthält.

5. Verwendung nach einem der Ansprüche 1 bis 4, wobei ein Gehalt des magnetischen Pulvers (A) 70 Massen-% oder mehr und 98 Massen-% oder weniger ist, bezogen auf 100-Massen-% der nichtflüchtigen Komponenten in der magnetischen Paste.

6. Verwendung nach einem der Ansprüche 1 bis 5, wobei das Dispergiermittel (C) ein Polyallylamin-Gerüst umfasst.

7. Verwendung nach einem der Ansprüche 1 bis 6, wobei die magnetische Paste gehärtet ist.

8. Platine, umfassend:
ein Substrat, das ein Durchgangsloch aufweist; und
ein gehärtetes Produkt einer magnetischen Paste, umfassend:
magnetisches Pulver (A);
ein Epoxidharz (B);
ein Dispergiermittel (C); und
ein Härtungsmittel (D), wobei
das Dispergiermittel (C) ein Polyestergerüst aufweist, das durch die nachstehende Formel (1) dargestellt ist, 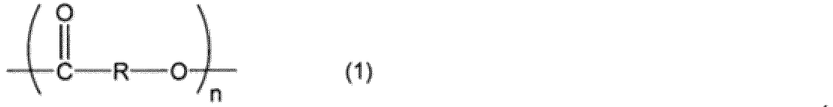 worin R unabhängig eine zweiwertige Kohlenwasserstoffgruppe mit 2 bis 10 Kohlenstoffatomen ist und n eine ganze Zahl von 2 bis 1.000 ist, wobei die magnetische Paste in das Durchgangsloch eingefüllt ist.

9. Platine nach Anspruch 8, wobei:
(i) ein Gehalt des Dispergiermittels (C) 0,1 Massen-% oder mehr und 5 Massen-% oder weniger ist, bezogen auf 100 Massen-% der nichtflüchtigen Komponenten in der magnetischen Paste; und/oder
(ii) das magnetische Pulver (A) zumindest eines ist, das aus Eisenoxidpulver und Metallpulver auf Eisenlegierungsbasis ausgewählt ist; und/oder
(iii) das magnetische Pulver (A) Eisenoxidpulver umfasst und
das Eisenoxidpulver Ferrit umfasst, das zumindest eines aus Ni, Cu, Mn und Zn enthält; und/oder
(iv) ein Gehalt des magnetischen Pulvers (A) 70 Massen-% oder mehr und 98 Massen-% oder weniger beträgt, bezogen auf 100 Massen-% der nichtflüchtigen Komponenten in der magnetischen Paste.

10. Platine nach Anspruch 8 oder 9, wobei das Dispergiermittel (C) ein Polyallylamin-Gerüst umfasst.

11. Induktionsspulenkomponente, umfassend eine Platine nach einem der Ansprüche 8, 9 oder 10.

12. Verfahren zur Herstellung einer Platine nach einem der Ansprüche 8, 9 oder 10 oder zur Herstellung einer Induktionsspulenkomponente nach Anspruch 11, wobei das Verfahren das Herstellen einer magnetischen Paste, umfassend das Rührmischen der Komponenten (A) - (D), umfasst, wobei das magnetische Pulver (A) Folgendes umfasst:
magnetisches Pulver (A-1), das einen durchschnittlichen Teilchendurchmesser von 1 µm oder mehr aufweist; und
magnetisches Pulver (A-2), das einen durchschnittlichen Teilchendurchmesser kleiner als 1 µm aufweist.

13. Verfahren zur Herstellung einer Platine oder einer Induktionsspulenkomponente nach Anspruch 12, wobei das Verfahren das Rührmischen von Komponenten (A) - (D) umfasst, wobei das magnetische Pulver (A) Folgendes umfasst:
magnetisches Pulver (A-1), das einen durchschnittlichen Teilchendurchmesser von 1 µm oder mehr und 10 µm oder weniger aufweist; und
magnetisches Pulver (A-2), das einen durchschnittlichen Teilchendurchmesser von 0,005 µm oder mehr und kleiner als 1 µm aufweist.

## Revendications

1. Utilisation d'une pâte magnétique pour remplir un trou traversant dans une carte de circuit imprimé, dans laquelle la pâte magnétique comprend :
une poudre magnétique (A) ;
une résine époxy (B) ;
un dispersant (C) ; et
un agent de durcissement (D), dans lequel
le dispersant (C) présente un squelette de polyester représenté par une formule (1) ci-dessous, 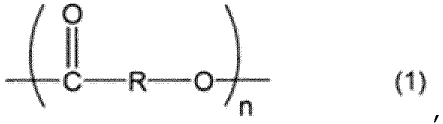
dans laquelle R est indépendamment un groupe hydrocarboné divalent présentant de 2 à 10 atomes de carbone, et n est un nombre entier de 2 à 1 000.

2. Utilisation selon la revendication 1, dans laquelle une teneur du dispersant (C) est de 0,1 % en masse ou plus et de 5 % en masse ou moins par rapport à 100 % en masse de composants non volatils dans la pâte magnétique.

3. Utilisation selon la revendication 1 ou 2, dans laquelle la poudre magnétique (A) est au moins une choisie parmi une poudre d'oxyde de fer et une poudre de métal à base d'alliage de fer.

4. Utilisation selon l'une quelconque des revendications 1 à 3, dans lequel
la poudre magnétique (A) inclut de la poudre d'oxyde de fer, et
la poudre d'oxyde de fer inclut de la ferrite contenant au moins un choisi parmi Ni, Cu, Mn et Zn.

5. Utilisation selon l'une quelconque des revendications 1 à 4, dans laquelle une teneur de la poudre magnétique (A) est de 70 % en masse ou plus et de 98 % en masse ou moins par rapport à 100 % en masse de composants non volatils dans la pâte magnétique.

6. Utilisation selon l'une quelconque des revendications 1 à 5, dans laquelle le dispersant (C) inclut un squelette de polyallylamine.

7. Utilisation selon l'une quelconque des revendications 1 à 6, dans laquelle la pâte magnétique est durcie.

8. Carte de circuit imprimé, comprenant :
un substrat présentant un trou traversant ; et
un produit durci d'une pâte magnétique comprenant :
une poudre magnétique (A) ;
une résine époxy (B) ;
un dispersant (C) ; et
un agent de durcissement (D), dans laquelle
le dispersant (C) présente un squelette de polyester représenté par une formule (1) ci-dessous, 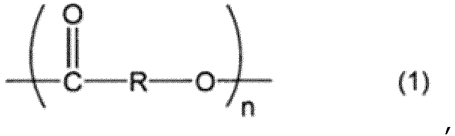
dans laquelle R est indépendamment un groupe hydrocarboné divalent présentant de 2 à 10 atomes de carbone, et n est un nombre entier de 2 à 1 000, la pâte magnétique étant versée dans le trou traversant.

9. Carte de circuit imprimé selon la revendication 8, dans laquelle :
(i) une teneur du dispersant (C) est supérieure ou égale à 0,1 % en masse et inférieure ou égale à 5 % en masse par rapport à 100 % en masse de composants non volatils dans la pâte magnétique ; et/ou
(ii) la poudre magnétique (A) est au moins une choisie parmi une poudre d'oxyde de fer et une poudre de métal à base d'alliage de fer ; et/ou
(iii) la poudre magnétique (A) inclut de la poudre d'oxyde de fer, et
la poudre d'oxyde de fer inclut de la ferrite contenant au moins un choisi parmi Ni, Cu, Mn et Zn ; et/ou
(iv) une teneur de la poudre magnétique (A) est de 70 % en masse ou plus et de 98 % en masse ou moins par rapport à 100 % en masse de composants non volatils dans la pâte magnétique.

10. Carte de circuit imprimé selon la revendication 8 ou 9, dans laquelle le dispersant (C) inclut un squelette de polyallylamine.

11. Composant inducteur, comprenant la carte de circuit imprimé selon l'une quelconque des revendications 8, 9 ou 10.

12. Procédé de production d'une carte de circuit imprimé selon l'une quelconque des revendications 8, 9 ou 10, ou de production d'un composant inducteur selon la revendication 11, le procédé comprenant la production d'une pâte magnétique comprenant un mélange par agitation des composants (A) à (D), dans lequel la poudre magnétique (A) comprend :
une poudre magnétique (A-1) présentant un diamètre de particule moyen de 1 µm ou plus ; et
une poudre magnétique (A-2) présentant un diamètre de particule moyen inférieur à 1 um.

13. Procédé de production de la carte de circuit imprimé ou du composant inducteur selon la revendication 12, le procédé comprenant un mélange par agitation des composants (A) à (D), dans lequel la poudre magnétique (A) comprend :
une poudre magnétique (A-1) présentant un diamètre de particule moyen de 1 um ou plus et de 10 um ou moins ; et
une poudre magnétique (A-2) présentant un diamètre de particule moyen de 0,005 um ou plus et de 1 um ou moins.
